# EUROPEAN PATENT APPLICATION

(11) **EP 4 391 772 A1**
(43) Date of publication of application: **26.06.2024**
(21) Application number: 23218711.2
(22) Date of filing: 20.12.2023
(51) Int. Cl.: H10K 59/122, H10K 59/131, H10K 59/80

(54) **DISPLAY DEVICE AND METHOD FOR MANUFACTURING THE SAME**

(30) Priority: 23.12.2022 KR 20220183587
(71) Applicant: LG Display Co., Ltd., Seoul 07336 (KR)
(72) Inventor: HEO, Joonyoung, 10845 Paju-si (KR)
(74) Representative: Morrall, Jonathan Ian McLachlan

(57) **Abstract**

Disclosed is a display device in which in each sub-pixel, a cathode electrode layer and a power connection line are electrically connected to each other via a structure providing an undercut at the undercut, such that power is stably supplied to each of a plurality of sub-pixels via the power connection line electrically connected to a power line.

## Description

### BACKGROUND

### Field

The present disclosure relates to a display device and a method for manufacturing the same. More particularly, the present disclosure relates to a display device having a structure for applying power to a cathode electrode layer and a method for manufacturing the same.

### Description of Related Art

A display device is implemented in very diverse forms such as televisions, monitors, smart phones, tablet PCs, laptops, and wearable devices.

An organic light-emitting display device (OLED) as an example of the display device is a self-luminous display device, and is not only advantageous in terms of power consumption due to low operation voltage thereof, but also has excellent advantages in color rendering, response speed, viewing angle, and contrast ratio.

The organic light-emitting display device may include a plurality of pixels at pixel areas defined by gate lines and data lines intersecting each other.

In this case, power may be applied to each of the plurality of pixels to drive each of the plurality of pixels.

### SUMMARY

The display device may include a power supply for applying power to a plurality of pixels and a power line for supplying power from the power supply thereto.

The power line may be a high-potential voltage (VDD) line or a low-potential voltage (VSS) line.

For example, when the display device is embodied as an organic light-emitting display device, the low-potential voltage line may apply a low-potential voltage to a cathode electrode constituting the organic light-emitting diode.

Applying the low-potential voltage to the cathode electrode maya allow each pixel including the organic light-emitting diode connected to the cathode electrode to emit light.

In order that the plurality of pixels disposed in a display area emit light, the low-potential voltage should be applied to the cathode electrode connected to the plurality of pixels. For this reason, the cathode electrode may be formed throughout the display area.

For example, the cathode electrode may be formed in a form of a surface electrode covering an entire surface of the display area and may be formed as a common electrode to the plurality of pixels.

However, when the cathode electrode is formed in the form of the surface electrode covering the entire surface of the display area, a parasitic capacitor may be generated between the cathode electrode and a data line disposed to overlap each other.

When, in this way, the parasitic capacitor is generated between the cathode electrode and the data line, a decrease in an electrical transmission rate (RC (resistive-capacitive) delay) occurs. Thus, a high-speed operation of the display device may not be achieved.

Accordingly, the inventors of the present disclosure conducted several experiments in order to reduce the decrease, and hence delay in the electrical transmission rate of the display device.

Based on several experiments, the inventors of the present disclosure have invented a display device having a structure capable of supplying stable power to the cathode electrode layer while reducing the generation of the parasitic capacitor between the cathode electrode layer and the data line, and a method for manufacturing the display device.

A technical purpose according to an embodiment of the present disclosure is to provide a display device having a structure capable of stably supplying power to a plurality of sub-pixels and a method for manufacturing the display device.

Moreover, a technical purpose according to an embodiment of the present disclosure is to provide a display device capable of improving light extraction efficiency in an organic light-emissive layer included in each of a plurality of sub-pixels and a method for manufacturing the display device.

Moreover, a technical purpose according to an embodiment of the present disclosure is to provide a display device capable of reducing generation of lateral leakage current in an organic light-emissive layer included in each of a plurality of sub-pixels, and a method for manufacturing the display device.

Moreover, a technical purpose according to an embodiment of the present disclosure is to provide a display device that can reduce the generation of the parasitic capacitor between the cathode electrode layer and the data line, and a method for manufacturing the display device.

Moreover, a technical purpose according to an embodiment of the present disclosure is to provide a display device capable of reducing damage to the organic light-emissive layer that may occur during a formation process of the organic light-emissive layer included in each of a plurality of sub-pixels, and a method for manufacturing the display device.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

According to an aspect of the disclosure, a display device is provided as defined in claim 1.

A display device according to an example of the present disclosure includes a plurality of sub-pixels; a power line for applying a voltage to the plurality of sub-pixels; and a plurality of power connection lines electrically connecting the plurality of sub-pixels to the power line.

Each of the sub-pixels includes an organic light-emissive layer, a cathode electrode layer, and a passivation layer stacked sequentially, wherein the organic light-emissive layers of the sub-pixels adjacent to each other are disconnected from each other, wherein the cathode electrode layers of the sub-pixels adjacent to each other are disconnected from each other, wherein the passivation layers of the sub-pixels adjacent to each other are disconnected from each other, wherein each of the sub-pixels includes a structure providing an undercut, wherein the power connection line is disposed to overlap the structure such that the power connection line is electrically connected to the cathode electrode layer at the undercut.

A display device according to a further example of the present disclosure includes a substrate having a plurality of sub-pixel areas defined thereon; a plurality of power connection lines disposed on the substrate; a plurality of structures, wherein each structure is included in each sub-pixel and is disposed on the power connection line, and provides an undercut exposing a portion of the power connection line; a bank layer disposed on the power connection line and including a first opening defined therein to expose the undercut; and an organic light-emissive layer, a cathode electrode layer, and a passivation layer sequentially stacked so as to cover the bank layer and the structure.

The power connection line is electrically connected to the cathode electrode layer at the undercut, wherein the organic light-emissive layers of the sub-pixels adjacent to each other are disconnected from each other, wherein the cathode electrode layers of the sub-pixels adjacent to each other are disconnected from each other, wherein the passivation layers of the sub-pixels adjacent to each other are disconnected from each other.

Further, a method for manufacturing a display device according to an example of the present disclosure includes forming a plurality of source and drain electrodes, a plurality of power connection lines, and a plurality of data lines on a substrate, and forming an overcoat layer thereon; forming a plurality of anode electrode layers and a plurality of second structure layers on the overcoat layer, wherein the plurality of anode electrode layers are electrically connected to the plurality of source and drain electrodes, respectively, wherein the plurality of second structure layers are electrically connected to the plurality of power connection lines, respectively; patterning the overcoat layer to form a plurality of first structure layers respectively under the plurality of the second structure layers, wherein each of the plurality of first structure layers provides an undercut; forming a bank layer having a plurality of first openings and a plurality of second openings defined therein, wherein each of the plurality of first openings exposes an outer periphery of each of the plurality of undercuts, wherein each of the plurality of second openings exposes a portion of each of the plurality of anode electrode layers; forming a first protective layer and a first photoresist film so as to expose the first opening and the second opening corresponding to a first sub-pixel, sequentially forming a first organic light-emissive layer rendering a first color, a first cathode electrode layer, and a first passivation layer, and then removing the first protective layer and the first photoresist film; forming a second protective layer and a second photoresist film so as to expose the first opening and the second opening corresponding to a second sub-pixel, sequentially forming a second organic light-emissive layer rendering a second color, a second cathode electrode layer, and a second passivation layer, and then removing the second protective layer and the second photoresist film after; and forming a third protective layer and a third photoresist film so as to expose the first opening and the second opening corresponding to a third sub-pixel, sequentially forming a third organic light-emissive layer rendering the third color, a third cathode electrode layer, and a third passivation layer, and then removing the third protective layer and the third photoresist film.

According to examples of the present disclosure, in each sub-pixel, the cathode electrode layer and the power connection line are electrically connected to each other at each undercut provided by the structure. Thus, the power may be stably supplied to each of the plurality of sub-pixels via the power connection line electrically connected to the power line.

According to the examples of the present disclosure, the adjacent organic light-emissive layers, the adjacent cathode electrode layers, and the adjacent passivation layers of adjacent sub-pixels are disconnected from each other, respectively. Thus, the light extraction efficiency from the organic light-emissive layer may be improved due to the occurrence of an out-coupling phenomenon that allows the light from the organic light-emissive layer to escape from the disconnected end to the outside. Thus, a low-power display device may be implemented.

According to examples of the present disclosure, the adjacent organic light-emissive layers, the adjacent cathode electrode layers, and the adjacent passivation layers of adjacent sub-pixels are disconnected from each other, respectively. Thus, the occurrence of lateral leakage current in the organic light-emissive layer that may occur when the adjacent organic light-emissive layers are integral with each other and extend continuously, and are connected to each other may be reduced.

According to examples of the present disclosure, the cathode electrode layer and the data line are disposed so as not to overlap each other in the vertical direction, thereby reducing the generation of the parasitic capacitor between the cathode electrode layer and the data line. Thus, the occurrence of the decrease in the electrical transmission rate (the RC delay) may be reduced.

According to examples of the present disclosure, the organic light-emissive layer rendering the first color, the cathode electrode layer, and the passivation layer may be formed, and subsequently, the organic light rendering the second color may be additionally formed using the same process as that on the organic light-emissive layer rendering the first color and subsequently, the organic light rendering the third color may be additionally formed using the same process as that on the organic light-emissive layer rendering the first color. Therefore, the passivation layer disposed on the organic light-emissive layer may act as a protective film that reduces deterioration of the organic light-emissive layer that may occur in a continuous process for forming the organic light-emissive layers corresponding to the sub-pixels. Thus, the damage to the organic light-emissive layer may be reduced.

Effects of the present disclosure are not limited to the effects mentioned above, and other effects not mentioned will be clearly understood by those skilled in the art from the description below.

in addition to the above effects, specific effects of the present disclosure are described together while describing specific details for carrying out the present disclosure.

### BRIEF DESCRIPTION OF DRAWINGS

FIG. 1 is a schematic plan view of a display device according to an embodiment of the present disclosure.
FIG. 2 is a circuit diagram of one sub-pixel of a display device according to an embodiment of the present disclosure.
FIG. 3A is an enlarged plan view of a plurality of sub-pixels of a display device according to an embodiment of the present disclosure as shown in FIG. 1.
FIG. 3B is an enlarged plan view of a plurality of sub-pixels of a display device according to another embodiment of the present disclosure as shown in FIG. 1.
FIG. 4 is a cross-sectional view of a plurality of sub-pixels of a display device according to an embodiment of the present disclosure as shown in FIG. 3A.
FIG. 5A to FIG. 5N are plan views of a plurality of sub-pixels in a process of manufacturing a display device according to an embodiment of the present disclosure.
FIGS. 6A to FIG. 6N are cross-sectional views corresponding to FIG. 5A to FIG. 5N.

### DETAILED DESCRIPTION

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the scope of the present disclosure as defined by the appended claims.

A shape, a size, a ratio, an angle, a number, etc. disclosed in the drawings for illustrating embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

The features of the various embodiments of the present disclosure may be partially or entirely combined with each other, and may be technically associated with each other or operate with each other. The embodiments may be implemented independently of each other and may be implemented together in an association relationship.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for illustrating embodiments.

Further, in a specific case, a term may be arbitrarily selected by the applicant, and in this case, the detailed meaning thereof will be described in a corresponding description section. Therefore, the terms used in the description below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B via another node unless a phrase 'immediately transferred' or 'directly transferred' is used.

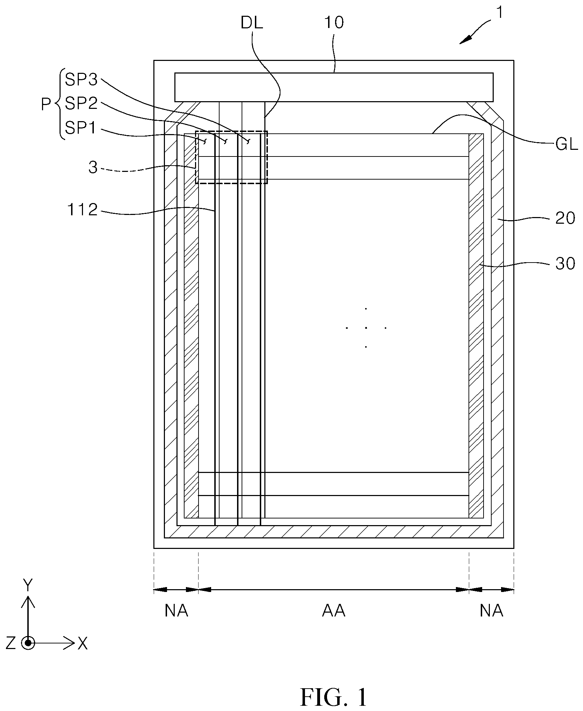

Hereinafter, a display device according to an embodiment of the present disclosure will be described in detail with reference to FIG. 1 to FIG. 4.

FIG. 1 is a schematic plan view of a display device according to an embodiment of the present disclosure.

An example in which a display device 1 as described below is embodied as an organic light-emitting diode display device will be described. However, the present disclosure is not limited thereto.

The display device 1 may include a display area AA and a non-display area NA surrounding the display area AA.

In the display area AA, a plurality of data lines DL extending in a first direction and a plurality of gate lines GL extending in a second direction intersecting the first direction may be disposed.

Each sub-pixel SP1, SP2, or SP3 may be disposed in each pixel area as each of intersection areas in which the data lines DL and the gate lines GL interest each other.

The sub-pixels SP1, SP2, and SP3 may be implemented to emit light of the same color such as white (W) light. Alternatively, the sub-pixels SP1, SP2, and SP3 may be implemented to emit light of different colors such as such as red (R), green (G), and blue (B).

For example, a combination of colors of light emitted from the sub-pixels SP1, SP2, and SP3 may be implemented as a combination of red (R), green (G), and blue (B) or a combination of red (R), green (G), blue (B), and white (W).

One pixel P may be configured as a combination of a plurality of sub-pixels SP1, SP2, and SP3 as described above.

Hereinafter, an example in which one pixel P is composed of a first sub-pixel SP1 rendering a first color, a second sub-pixel SP2 rendering a second color, and a third sub-pixel SP3 rendering a third color will be described.

In this case, the first color may be red (R), the second color may be green (G), and the third color may be blue (B). However, the present disclosure is not limited thereto.

A plurality of sub-pixels SP1, SP2, and SP3 may be arranged in a matrix form composed of a plurality of rows and columns.

As used herein, the first direction may be a column direction and is defined as a Y-axis direction. The second direction may be a row direction and may be defined as an X-axis direction.

In the non-display area NA, a plurality of lines and pads supplying various signals and power to the pixel may be disposed.

A data driver circuit (D-IC) 10 may be disposed at one side of the non-display area NA.

The data driver circuit 10 may apply a data signal to the data line DL, and may apply a driving voltage such as a high-potential voltage VDD or a low-potential voltage VSS to the pixel P.

The power line 20 may extend along an edge of the display area AA except for one side of the non-display area NA where the data driver circuit 10 is disposed.

For example, a gate driver 30 for applying a gate signal to the gate line GL may be disposed in a portion of the non-display area NA positioned on each of both opposing sides of the display area AA. The power line 20 capable of applying a voltage to an anode electrode or a cathode electrode in the pixel P may extend along an outer edge of the gate driver 30.

The power line 20 may be a low-potential voltage line capable of applying the low-potential voltage VSS to the cathode electrode of the pixel P. However, the present disclosure is not limited thereto. A high-potential voltage line capable of applying the high-potential voltage VDD to a thin-film transistor of the pixel P may be additionally disposed.

In the display area AA, a plurality of power connection lines 112 electrically connecting the power line 20 and the plurality of sub-pixels SP1, SP2, and SP3 respectively such that the low-potential voltage can be applied to the plurality of sub-pixels SP1, SP2, and SP3 may be disposed.

For example, the plurality of power connection lines 112 may extend in the first direction in which the plurality of data lines DL extend.

The plurality of power connection lines 112 and the plurality of data lines DL may be alternately arranged with each other in the second direction.

One power connection line 112 may extend across a plurality of sub-pixels arranged in the column direction so as to be electrically connected to a portion of the power line 20 disposed adjacent to a lower end of the display area AA.

Accordingly, a plurality of sub-pixels arranged in the same column direction may be electrically connected to the single power connection line 112 and may receive the low-potential voltage from the power line 20 via the single power connection line 112.

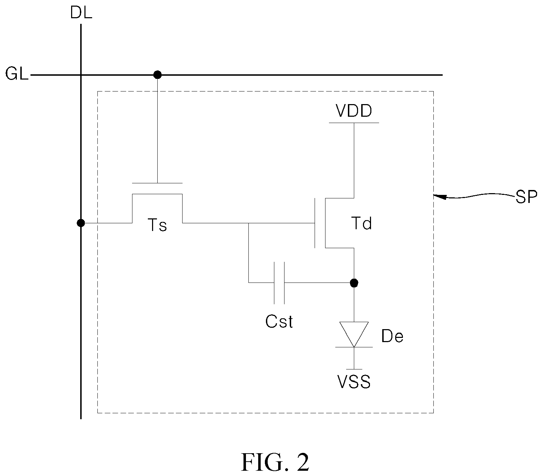

FIG. 2 is a circuit diagram of one sub-pixel of a display device according to an embodiment of the present disclosure.

Each of the sub-pixels SP1, SP2, and SP3 disposed in each of the intersections of the gate lines GL and the data lines DL intersecting each other as described above may include a switching thin-film transistor Ts, a driving thin-film transistor Td, and a storage capacitor Cst, and a light-emitting diode De.

A gate electrode of the switching thin-film transistor Ts may be connected to the gate line GL while a source electrode thereof may be connected to the data line DL.

A gate electrode of the driving thin-film transistor Td may be connected to a drain electrode of the switching thin-film transistor Ts, while a source electrode thereof may be connected to the high-potential voltage VDD.

An anode electrode of the light-emitting diode De may be connected to a drain electrode of the driving thin-film transistor Td, while a cathode electrode thereof may be connected to the low-potential voltage VSS.

One side and the other side of the storage capacitor Cst may be connected to the gate electrode and the drain electrode of the driving thin-film transistor Td, respectively.

The display device 1 including the sub-pixel SP1, SP2, and SP3, each of having a structure of such a circuit diagram may display an image as follows.

The switching thin-film transistor Ts may be turned on based on the gate signal applied via the gate line GL. The data signal applied to the data line DL may be applied to the gate electrode of the driving thin-film transistor Td and one electrode of the storage capacitor Cst via the switching thin-film transistor Ts.

The driving thin-film transistor Td may be turned on based on the data signal so as to control a current flowing through the light-emitting diode De. Thus, an image may be displayed.

The light-emitting diode De may emit light based on a current of the high-potential voltage VDD transmitted through the driving thin-film transistor Td.

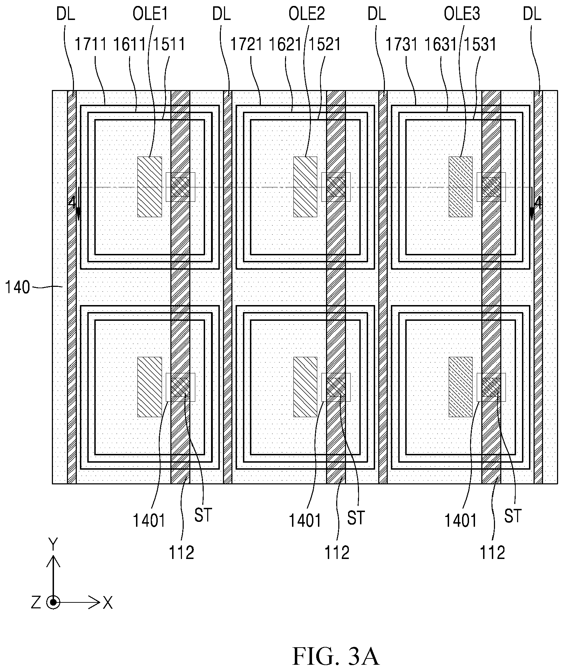

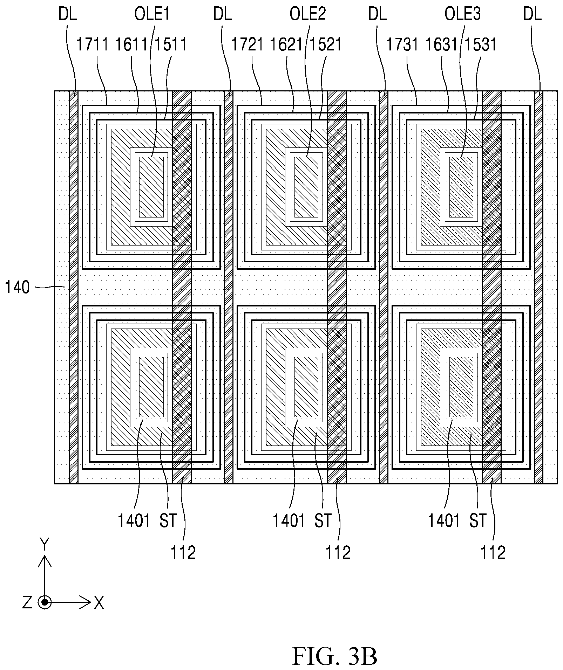

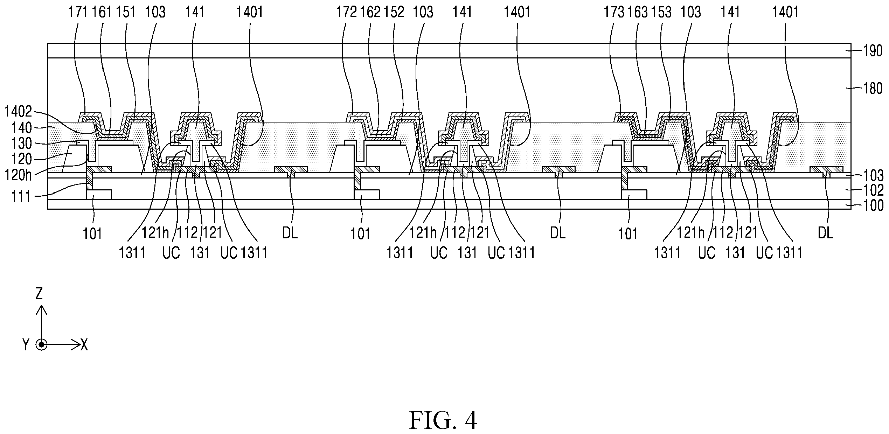

FIG. 3A and FIG. 3B are respectively enlarged plan views of a plurality of sub-pixels of a display device according to an embodiment of the present disclosure as shown in FIG. 1. FIG. 4 is a cross-sectional view of a plurality of sub-pixels of a display device according to an embodiment of the present disclosure as shown in FIG. 3A.

Specifically, FIG. 3A is an enlarged view of a plurality of sub-pixels corresponding to an area denoted by a reference numeral 3 in FIG. 1.

Hereinafter, one sub-pixel is described by way of example. This description may be equally applied to other sub-pixels when there is no special description.

Referring to FIG. 3A and FIG. 4, a thin-film transistor including an active layer 101 may be disposed on a substrate 100. In this case, the thin-film transistor may be the driving thin-film transistor Td or the switching thin-film transistor Ts.

A buffer layer may be additionally disposed between the substrate 100 and the thin-film transistor.

The thin-film transistor may include the active layer 101, a gate electrode, and a pair of source and drain electrodes 111.

A first insulating layer 102 as an interlayer insulating layer may be disposed on the active layer 101 and the gate electrode. Each of the source and drain electrodes 111 may be electrically connected to the active layer 101 via a contact-hole formed in the first insulating layer 102.

A second insulating layer 103 may be additionally disposed on the first insulating layer 102 and the source and drain electrodes 111. Each of the source and drain electrodes 111 may be disposed on a top face of the second insulating layer 103 so as to be connected to the active layer 101 via the contact-hole formed in the first insulating layer 102 and a contact-hole formed in the second insulating layer 103.

The power connection line 112 and the data line DL may be disposed on the second insulating layer 103. The power connection line 112 and the data line DL and the source and drain electrodes 111 may be disposed on the same layer.

The power connection lines 112 and the data lines DL may extend in parallel to each other in the first direction and may be alternately arranged with each other in the second direction (see Fig. 1).

Accordingly, the plurality of data lines DL and the plurality of power connection lines 112 may be arranged so as not to overlap each other in a vertical direction, thereby reducing generation of a parasitic capacitor that may be generated between the data line DL and the power connection line 112.

An overcoat layer 120 may be formed on the source and drain electrodes 111. An anode electrode layer 130 may be formed on the overcoat layer 120.

The overcoat layer 120 may be made of an organic material.

The anode electrode layer 130 may be electrically connected to each of the source and drain electrodes 111 via a contact-hole 120h formed in the overcoat layer 120.

A first structure layer 121 made of the same material as that of the overcoat layer 120 may be disposed on the power connection line 112.

The first structure layer 121 may be formed by patterning the overcoat layer 120 in a shape of an island.

The first structure layer 121 may overlap the power connection line 112 in a vertical direction.

The first structure layer 121 may be formed to have a taper shape in which a width thereof decreases as the first structure layer 121 extends in an upward direction.

A width in a left-right direction (x-direction according to Fig. 4) of a lower surface of the first structure layer 121 may be smaller than a width in a left-right direction (x-direction according to Fig. 4) of the power connection line 112.

Accordingly, a partial area of an upper surface of the power connection line 112 that does not overlap with the first structure layer 121 and a side surface of the power connection line 112 may not be covered with the first structure layer 121 so as to be exposed to an outside.

The partial area of the upper surface of the power connection line 112 exposed to the outside in this way may define an undercut UC.

For example, the undercut UC may be formed along a perimeter of the lower surface of the first structure layer 121. A portion of the power connection line 112 corresponding to the undercut UC may be exposed to the outside while not being covered with the first structure layer 121.

A second structure layer 131 made of the same material as that of the anode electrode layer 130 may be disposed on the first structure layer 121.

The second structure layer 131 may be formed by patterning the anode electrode layer 130 in a shape of an island.

The second structure layer 131 may be disposed to overlap the first structure layer 121 and the power connection line 112 in a vertical direction.

The second structure layer 131 may be electrically connected to the power connection line 112 via a contact-hole 121h of the first structure layer 121.

A width in a left-right direction (x-direction according to Fig. 4) of the second structure layer 131 may be larger than a width in a left-right direction (x-direction according to Fig. 4) of each of the upper and lower surfaces of the first structure layer 121 disposed thereunder.

Accordingly, the second structure layer 131 may include a protrusion 1311 protruding outwardly beyond each of the upper and lower surfaces of the first structure layer 121.

Due to the protrusion 1311 of the second structure layer 131 formed in this way, the undercut UC may be formed on the power connection line 112 and along an outer perimeter of the lower surface of the first structure layer 121.

In a plan view, at least a portion of the undercut UC may be positioned inwardly of the second structure layer 131.

Therefore, the outermost boundary of the undercut UC may be positioned outwardly of the second structure layer 131. However, the present disclosure is not limited thereto, and the outermost boundary of the undercut UC may be positioned inwardly of the second structure layer 131 or may coincide with a side end of the second structure layer 131.

A bank layer 140 may be formed on the anode electrode layer 130, the second structure layer 131, and the data line DL.

The bank layer 140 may function as a pixel definition layer PDL that defines each of the plurality of sub-pixels SP1, SP2, and SP3.

Therefore, the bank layer 140 as the pixel definition layer may be disposed between adjacent ones of the sub-pixels SP1, SP2, and SP3 so as to define a boundary between adjacent ones of the sub-pixels SP1, SP2, and SP3 rendering different colors, and to prevent color mixing of light beams respectively emitted from adjacent ones of the sub-pixels SP1, SP2, and SP3.

The bank layer 140 disposed on the power connection line 112 may include a first opening 1401 opened to expose the undercut UC.

As used herein, "the first opening 1401 of the bank layer 140 exposes the undercut UC" may mean that the bank layer 140 has an opening pattern so as not to cover the undercut UC.

Specifically, the outermost boundary of the first opening 1401 may be positioned outwardly of the outermost boundary of the undercut UC, so that the first opening 1401 may receive the undercut UC.

Accordingly, a partial area of the undercut UC and a partial area of the upper surface of the power connection line 112 may be exposed to the outside through the first opening 1401.

A third structure layer 141 made of the same material as that of the bank layer 140 may be disposed on the second structure layer 131.

The third structure layer 141 may be formed by patterning the bank layer 140 in a shape of an island.

The third structure layer 141 may be disposed to overlap the second structure layer 131, the first structure layer 121, and the power connection line 112 in a vertical direction.

The third structure layer 141 may be formed to have a taper shape in which a width thereof decreases as the third structure layer 141 extends upwardly.

A width in a left-right direction (x-direction according to Fig. 4) of the third structure layer 141 may be smaller than a width in a left-right direction (x-direction according to Fig. 4) of the upper surface of the second structure layer 131 disposed thereunder.

Accordingly, an upper surface of the protrusion 1311 of the second structure layer 131 protruding outwardly of the first structure layer 121 may be exposed to the outside while not being covered with the third structure layer 141.

The first structure layer 121, the second structure layer 131, and the third structure layer 141 sequentially stacked in this way may constitute a structure ST.

Accordingly, the structure ST may overlap the power connection line 112 so as to provide the undercut UC exposing the partial area of the upper surface of the power connection line 112.

Moreover, the bank layer 140 may include a second opening 1402 opened to expose a partial area of the anode electrode layer 130.

The second opening 1402 formed in the first sub-pixel SP1 may define a first light-emissive area OLE1. The second opening 1402 formed in the second sub-pixel SP2 may define a second light-emissive area OLE2. The second opening 1402 formed in the third sub-pixel SP3 may define a third light-emissive area OLE3.

On the bank layer 140, an organic light-emissive layer, a cathode electrode layer, and a passivation layer may be sequentially stacked.

Specifically, a first organic light-emissive layer 151 rendering a first color, a first cathode electrode layer 161, and a first passivation layer 171 may be disposed in the first sub-pixel SP1. In the second sub-pixel SP2, a second organic light-emissive layer 152 rendering a second color, a second cathode electrode layer 162, and a second passivation layer 172 may be disposed. A third organic light-emissive layer 153 rendering a third color, a third cathode electrode layer 163, and a third passivation layer 173 may be disposed in the third sub-pixel SP3.

In this case, organic light-emissive layers, cathode electrode layers, and passivation layers of sub-pixels adjacent to each other may be disconnected from each other.

As used herein, the disconnection between two components may mean that the two components are physically separated from each other, and may mean that the two components are not electrically connected to each other.

However, even when the two components are disconnected from each other, the two components may be electrically connected to each other in an indirect way via another middle medium.

For example, the first organic light-emissive layer 151 and the second organic light-emissive layer 152 adjacent to each other may be disconnected from each other. The second organic light-emissive layer 152 and the third organic light-emissive layer 153 adjacent to each other may be disconnected from each other. The third organic light-emissive layer 153 and the first organic light-emissive layer 151 adjacent to each other may be disconnected from each other.

Moreover, the first cathode electrode layer 161 and the second cathode electrode layer 162 adjacent to each other may be disconnected from each other. The second cathode electrode layer 162 and the third cathode electrode layer 163 adjacent to each other may be disconnected from each other. The third cathode electrode layer 163 and the first cathode electrode layer 161 adjacent to each other may be disconnected from each other.

Moreover, the first passivation layer 171 and the second passivation layer 172 adjacent to each other may be disconnected from each other. The second passivation layer 172 and the third passivation layer 173 adjacent to each other may be disconnected from each other. The third passivation layer 173 and the first passivation layer 171 adjacent to each other may be disconnected from each other.

The outermost boundary 1511 of the first organic light-emissive layer 151, the outermost boundary 1611 of the first cathode electrode layer 161, and the outermost boundary 1711 of the first passivation layer 171 may be disposed in the first sub-pixel SP1 formed between adjacent data lines DL.

Accordingly, the first organic light-emissive layer 151, the first cathode electrode layer 161, and the first passivation layer 171 may not overlap the data line DL in the vertical direction.

Moreover, the outermost boundary 1521 of the second organic light-emissive layer 152, the outermost boundary 1621 of the second cathode electrode layer 162, and the outermost boundary 1721 of the second passivation layer 172 may be disposed in the second sub-pixel SP2 formed between adjacent data lines DL.

Accordingly, the second organic light-emissive layer 152, the second cathode electrode layer 162, and the second passivation layer 172 may not overlap the data line DL in the vertical direction.

Moreover, the outermost boundary 1531 of the third organic light-emissive layer 153, the outermost boundary 1631 of the third cathode electrode layer 163, and the outermost boundary 1731 of the third passivation layer 173 may be disposed in the third sub-pixel SP3 formed between adjacent data lines DL.

Accordingly, the third organic light-emissive layer 153, the third cathode electrode layer 163, and the third passivation layer 173 may not overlap the data line DL in the vertical direction.

When the cathode electrode layers adjacent to each other are not disconnected from each other but are integral with each other into a single electrode structure which continuously extends so as to cover an entirety of the display area, the cathode electrode layer is disposed to overlap the data line, such that an unintended parasitic capacitor may be generated between the cathode electrode layer and the data line.

When the parasitic capacitor is generated in this way, the RC delay may increase.

The RC delay refers to a value obtained by multiplying a resistance R and a capacitance C by each other, and causes a decrease in an electrical transmission rate.

Therefore, when the RC delay increases, the reduction in the electrical transmission rate increases. Thus, the display device cannot operate at a high-speed.

However, according to an embodiment of the present disclosure, the cathode electrode layer and the data line may be disposed so as not to overlap with each other in the vertical direction, thereby reducing the occurrence of the parasitic capacitor that may be generated between the cathode electrode layer and the data line.

Accordingly, according to an embodiment of the present disclosure, greatly reducing the occurrence of the RC delay may allow the display device to operate at the high speed.

In an area corresponding to the second opening 1402 of the first sub-pixel SP1 of the bank layer 140, the first organic light-emissive layer 151, the first cathode electrode layer 161, and the first passivation layer 171 may be sequentially stacked. An area where the anode electrode layer 130, the first organic light-emissive layer 151, and the first cathode electrode layer 161 overlap each other may be a first light-emissive area OLE1 emitting light.

Moreover, in an area corresponding to the second opening 1402 of the second sub-pixel SP2 of the bank layer 140, the second organic light-emissive layer 152, the second cathode electrode layer 162, and the second passivation layer 172 may be sequentially stacked. An area where the anode electrode layer 130, the second organic light-emissive layer 152, and the second cathode electrode layer 162 overlap each other may be a second light-emissive area OLE2 emitting light.

Moreover, in an area corresponding to the second opening 1402 of the third sub-pixel SP3 of the bank layer 140, the third organic light-emissive layer 153, the third cathode electrode layer 163, and the third passivation layer 173 may be sequentially stacked. An area where the anode electrode layer 130, the third organic light-emissive layer 153, and the third cathode electrode layer 163 overlap each other may be a third light-emissive area OLE3 emitting light.

The first organic light-emissive layer 151, the second organic light-emissive layer 152, and the third organic light-emissive layer 153 may include light-emissive layers (EML) that emit red, green, and blue light beams, respectively. The light-emissive layer may be made of a phosphorescent material or a fluorescent material. A specific material thereof is not particularly limited.

For example, a hole injection layer (HIL) and/or a hole transporting layer (HTL) may be additionally disposed between the anode electrode layer 130 and the organic light-emissive layer (EML). An electron transport layer (ETL) and/or an electron injection layer (HIL) may be disposed between the light-emissive layer (EML) and the cathode electrode layer.

When the organic light-emissive layers adjacent to each other are not disconnected from each other but are integral with each other into a single structure which continuously extends so as to cover an entirety of the display area, light which is generated from the light-emissive area but does not escape to the outside may continue to be reflected from an interface, propagate to a side surface, and then disappear.

However, according to an embodiment of the present disclosure, the organic light-emissive layers of adjacent sub-pixels are disconnected from each other, the cathode electrode layers of adjacent sub-pixels are disconnected from each other, and the passivation layers of adjacent sub-pixels are disconnected from each other. Thus, a travel path of the light from the organic light-emissive layer changes at the disconnected end such that the light may escape to the outside.

Accordingly, according to an embodiment of the present disclosure, light extraction efficiency from the organic light-emissive layer may be further improved based on occurrence of an out-coupling phenomenon.

Moreover, according to an embodiment of the present disclosure, the organic light-emissive layers of adjacent sub-pixels are disconnected from each other, the cathode electrode layers of adjacent sub-pixels are disconnected from each other, and the passivation layers of adjacent sub-pixels are disconnected from each other. Thus, occurrence of lateral leakage current in the organic light-emissive layer which may occur when the organic light-emissive layers are connected to each other and extend continuously may be reduced.

The low-potential voltage VSS should be applied to the cathode electrode layer to operates each of the sub-pixels SP1, SP2, and SP3.

However, according to an embodiment of the present disclosure, the cathode electrode layers of the sub-pixels SP1, SP2, and SP3 adjacent to each other are disconnected from each other. Thus, the low-potential voltage VSS may be applied to each of the cathode electrode layers included in each of the sub-pixels SP1, SP2, and SP3 via the power connection line 112.

In the first sub-pixel SP1, the first cathode electrode layer 161 and the power connection line 112 are brought into contact with each other at the undercut UC of the power connection line 112 disposed under the structure ST. Thus, the first cathode electrode layer 161 and the power connection line 112 may be electrically connected to each other.

Specifically, the first organic light-emissive layer 151, the first cathode electrode layer 161, and the first passivation layer 171 may contact the power connection line 112 at the undercut UC.

For example, the first organic light-emissive layer 151 may be formed in the first opening 1401 so as to contact a side surface of the power connection line 112.

In this case, the first organic light-emissive layer 151 may contact a partial area of the undercut UC.

The first cathode electrode layer 161 formed on the first organic light-emissive layer 151 may be formed in the first opening 1401 so as to contact a partial area of the undercut UC.

The first cathode electrode layer 161 may be made of a material having a relatively superior step coverage to that of a material of the first organic light-emissive layer 151. Accordingly, an end of the first cathode electrode layer 161 adjacent to the undercut UC may be positioned closer to an inner side of the undercut UC, that is, to the structure ST than an end of the first organic light-emissive layer 151 adjacent to the undercut UC may be.

Therefore, the first cathode electrode layer 161 may be formed to cover an entirety of the first organic light-emissive layer 151. Thus, the outermost boundary 1611 of the first cathode electrode layer 161 may be positioned outwardly of the outermost boundary 1511 of the first organic light-emissive layer 151.

The first cathode electrode layer 161 formed in this way may be in contact with a partial area of the undercut UC and thus may be electrically connected to the power connection line 112.

Accordingly, the first cathode electrode layers 161 disconnected from each other may be electrically connected to the power line 20 via one power connection line 112 extending across the plurality of first sub-pixels SP1. Thus, the low-potential voltage may be applied to each of the first cathode electrode layers 161.

The first passivation layer 171 formed on the first cathode electrode layer 161 may be formed in the first opening 1401 so as to contact a partial area of the undercut UC.

However, the present disclosure is not limited thereto, and the first passivation layer 171 may additionally contact a side surface of the first structure layer 121. Alternatively, the first passivation layer 171 may contact a side surface of the first structure layer 121 of the structure ST while not directly contacting the undercut UC.

The first passivation layer 171 may be made of a material having a relatively superior step coverage (that is to say a relatively uniform thickness across a step) to that of a material of the first cathode electrode layer 161. Thus, an end of the first passivation layer 171 adjacent to the undercut UC may be positioned closer to the inner side of the undercut UC, (the structure ST) than an end of the first cathode electrode layer 161 adjacent to the undercut UC may be. Therefore, the first passivation layer 171 may be formed to cover an entirety of the first cathode electrode layer 161. Thus, the outermost boundary 1711 of the first passivation layer 171 may be positioned outwardly of the outermost boundary 1611 of the first cathode electrode layer 161.

In this way, according to an embodiment of the present disclosure, in each sub-pixel, the cathode electrode layer and the power connection line may be electrically connected to each other via the structure providing the undercut at the undercut. Thus, the power may be stably supplied to each of the plurality of sub-pixels via the power connection line electrically connected to the power line.

Moreover, according to an embodiment of the present disclosure, the undercut may be formed along at least both side surfaces or the perimeter of the structure, and the cathode electrode layer and the power connection line contact each other at the undercut. Thus, even when the undercut structure at one side is not properly formed due to an external factor such as a process error, the undercut structure at the other side may be used.

Therefore, according to an embodiment of the present disclosure, the power may be stably supplied to each of the plurality of sub-pixels via the power connection line electrically connected to the power line.

On the structure ST of the first sub-pixel SP1, the first organic light-emissive layer 151, the first cathode electrode layer 161, and the first passivation layer 171 may be sequentially stacked (see Fig. 4).

Specifically, the first organic light-emissive layer 151, the first cathode electrode layer 161, and the first passivation layer 171 may be formed to cover the third structure layer 141.

The first organic light-emissive layer 151, the first cathode electrode layer 161, and the first passivation layer 171 may be formed to cover the protrusion 1311 of the second structure layer 131, and may extend to cover a side surface of the second structure layer 131.

In this case, each of the first organic light-emissive layer 151, the first cathode electrode layer 161, and the first passivation layer 171 may be disconnected from the first structure layer 121 disposed under the second structure layer 131, and may be formed in a shape of an island.

The first cathode electrode layer 161 disposed on the third structure layer 141 may be electrically connected to the second structure layer 131 made of the same material as that of the anode electrode layer 130.

Since the second structure layer 131 is electrically connected to the underlying power connection line 112 via the contact-hole 121h of the first structure layer 121, the first cathode electrode layer 161 disposed on the third structure layer 141, the second structure layer 131, and the power connection line 112 may be electrically connected to each other.

The first cathode electrode layer 161 and the second structure layer 131 are made of a conductive material such as metal. Thus, as the first cathode electrode layer 161, the second structure layer 131, and the power connection line 112 are electrically connected to each other, a total resistance of the power connection line 112 may be reduced.

The structure as described above in which the first organic light-emissive layer 151, the first cathode electrode layer 161, and the first passivation layer 171 of the first sub-pixel SP1 are connected to the undercut UC may be equally applied to the second sub-pixel SP2 and the third sub-pixel SP3. Thus, duplicate descriptions thereof are omitted.

FIG. 3B is an enlarged plan view of a plurality of sub-pixels of a display device according to another embodiment of the present disclosure as shown in FIG. 1.

Referring to FIG. 3B, the structure ST of the first sub-pixel SP1 may continuously formed along the perimeter of the first light-emissive area OLE1. The structure ST of the second sub-pixel SP2 may be continuously formed along the perimeter of the second light-emissive area OLE2. The structure ST of the third sub-pixel SP3 may be continuously formed along the perimeter of the third light-emissive area OLE3.

In this way, the structure ST may be continuously formed along the perimeter of each light-emissive area, and thus, the undercut UC provided by the structure ST may be continuously formed along the perimeter of each light-emissive area.

The structure ST and the undercut UC provided by the structure ST are continuously formed along the perimeter of the light-emissive area. Thus, even when the structure ST or the undercut structure UC at one side is not properly formed due to the external factor such as the process error, the cathode electrode layer and the power connection line may be stably connected to each other using the structure ST and the undercut structure UC at the other side.

Although not shown in the drawing, the structure ST may be formed discontinuously along the perimeter of each light-emissive area. An arrangement form of the structure ST is not particularly limited.

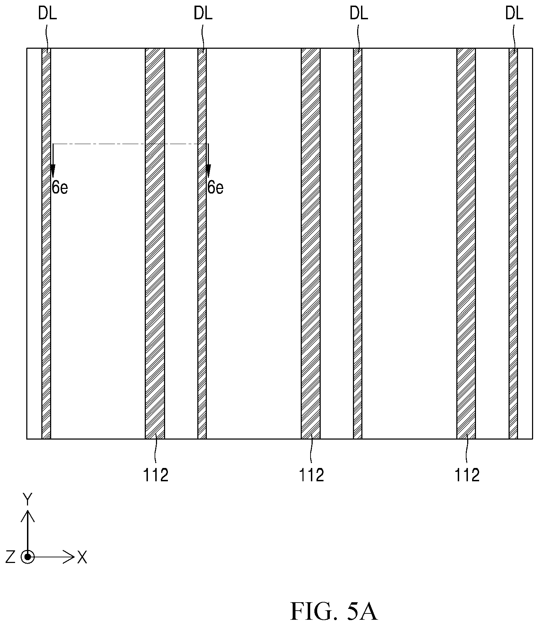

FIG. 5A to FIG. 5N are plan views of a plurality of sub-pixels in a process of manufacturing a display device according to an embodiment of the present disclosure.

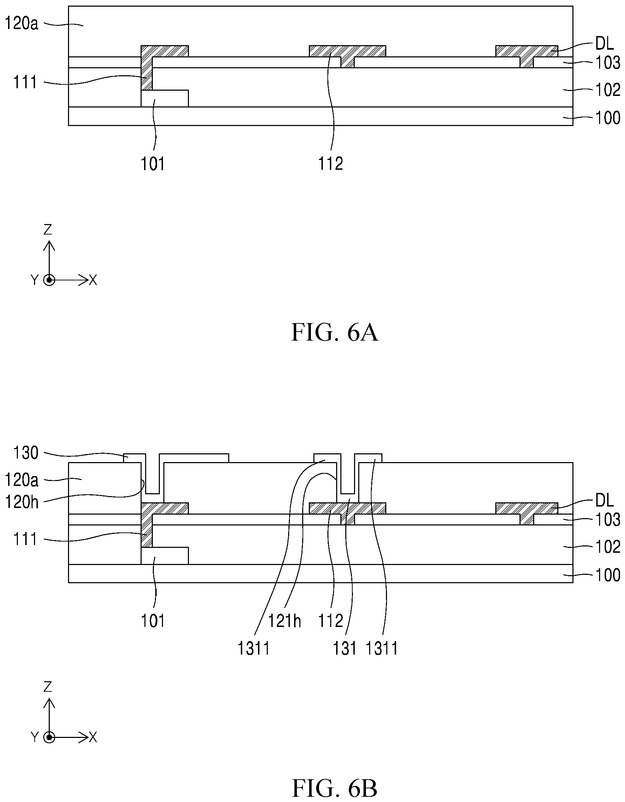

FIGS. 6A to FIG. 6N are cross-sectional views corresponding to FIG. 5A to FIG. 5N.

For the convenience of illustration, each of the plan views of FIG. 5A to FIG. 5N shows only some components as shown in each of the cross-sectional views of FIG. 6A to FIG. 6N.

A scheme for forming a pattern in each of layers as described below may employ a technique performed by a person skilled in the art, such as a photolithography process including deposition, photoresist application (PR coating), exposure, development, etching, and photoresist stripping (PR strip). A detailed description thereof will be omitted.

For example, depositing a metal material may be performed using sputtering. Depositing a semiconductor or insulating film may be performed using PECVD (Plasma Enhanced Vapor Deposition). Dry etching or wet etching may be selected based on a material subjected to the etching. A technique performed by a person skilled in the art may be applied thereto.

Referring to FIG. 5A and FIG. 6A, a thin-film transistor including the active layer 101 may be formed on the substrate 100, and the first insulating layer 102 and the second insulating layer 103 may be sequentially formed thereon.

The source and drain electrodes 111 connected to the active layer 101 may be formed on the second insulating layer 103.

Moreover, the plurality of power connection lines 112 and the plurality of data lines DL may be formed on the second insulating layer 103.

The source and drain electrodes 111, the power connection line 112, and the data line DL may be made of the same material and may be formed in the same layer and may be formed using the same patterning process.

The plurality of power connection lines 112 and the plurality of data lines DL may be formed to extend in the first direction and may be alternately arranged with each other in the second direction.

The overcoat film 120a may be formed on the plurality of source and drain electrodes 111, the plurality of power connection lines 112, and the plurality of data line DL.

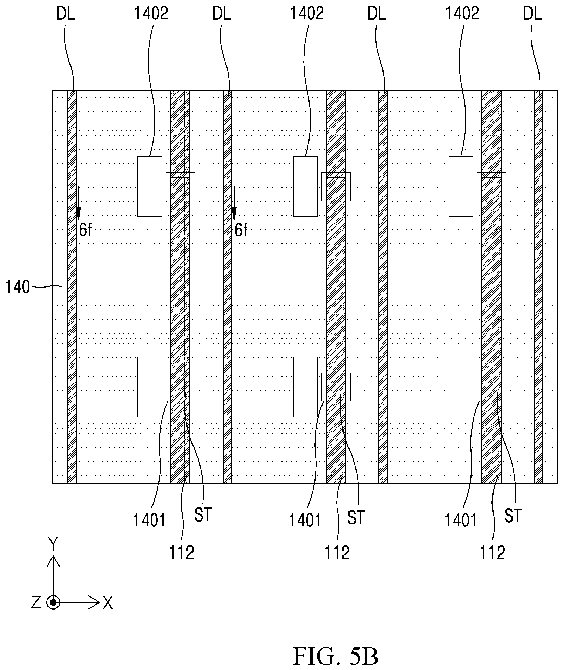

Referring to FIG. 5B and FIG. 6B, the contact-hole 120h connected to each of the source and drain electrodes 111 may be formed in the overcoat film 120a. Each of the plurality of anode electrode layers 130 electrically connected to each of the source and drain electrodes 111 via the contact-hole 120h may be formed on the overcoat film 120a.

Moreover, the contact-hole 121h connected to each power connection line 112 may be formed in the overcoat film 120a. Each of the plurality of second structure layers 131 electrically connected to the power connection line 112 via the contact-hole 121h may be formed on the overcoat film 120a.

The anode electrode layer 130 and the second structure layer 131 may be made of the same material and may be formed in the same layer and using the same patterning process.

The second structure layer 131 may be formed to have a pair of protrusions 1311 protruding outwardly.

For example, one side end of the protrusion 1311 of the second structure layer 131 may be positioned inwardly of one side end of the power connection line 112. However, the present disclosure is not limited thereto.

In the plan view, the protrusion 1311 of the second structure layer 131 may be continuously formed along the perimeter of the second structure layer 131.

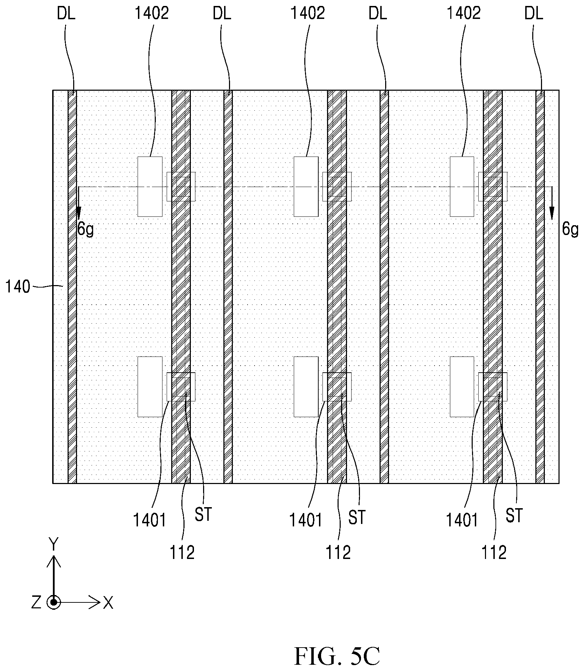

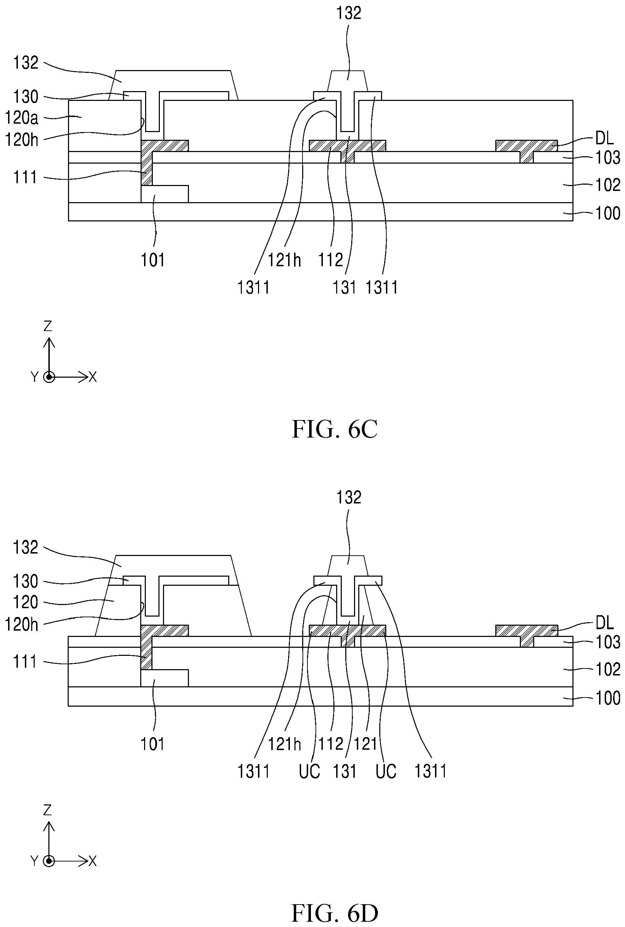

Referring to FIG. 5C and FIG. 6C, a photoresist layer 132 having a predetermined pattern may be formed on the anode electrode layer 130 and the second structure layer 131.

For example, the photoresist layer 132 may be formed by depositing a photoresist material and patterning the same so as to have the predetermined pattern.

The photoresist layer 132 formed on the anode electrode layer 130 may be formed to have a larger area than that of the anode electrode layer 130 to cover an entirety of the anode electrode layer 130.

The photoresist layer 132 formed on the second structure layer 131 may be formed to have a smaller area than that of the second structure layer 131 so that an edge area as a partial area of the protrusion 1311 of the second structure layer 131 is exposed.

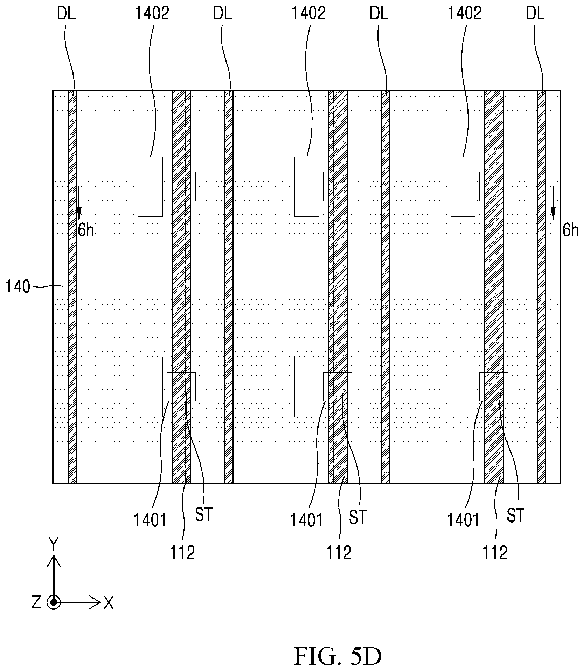

Referring to FIG. 5D and FIG. 6D, the overcoat layer 120 and the first structure layer 121 may be formed by etching the overcoat film 120a using the photoresist layer 132 as a photomask.

Accordingly, the overcoat layer 120 and the first structure layer 121 may be made of the same material and may be formed in the same layer and using the same patterning process.

For example, the overcoat film 120a may be patterned in a dry etching scheme.

The overcoat layer 120 may be formed under the anode electrode layer 130.

The first structure layer 121 formed by patterning the overcoat film 120a may be formed under the second structure layer 131.

Specifically, the second structure layer 131, and the photoresist layer 132 formed on the second structure layer 131 may serve as a photomask used to perform patterning of the overcoat film 120a to form the first structure layer 121.

In this case, the first structure layer 121 may be formed in a tapered shape in which the width thereof decreases as the first structure layer 121 extends upwardly.

The outermost boundary of the lower surface of the first structure layer 121 may be formed to be positioned inward of the outermost boundary of the protrusion 1311 of the second structure layer 131.

Therefore, the first structure layer 121 may be formed to have a width in the left-right direction (x-direction according to Fig. 4) smaller than that of the power connection line 112, such that the edge area of the power connection line 112 may not be covered with the first structure layer 121 and may be exposed to form the undercut UC.

In the plan view, the undercut UC may be blocked with the protrusion 1311 of the second structure layer 131 so as not to be exposed to the outside. However, the present disclosure is not limited thereto, and an upper partial area positioned at an edge of the undercut UC may be exposed to the outside in the plan view.

Accordingly, each of a plurality of first structure layers 121 defining the undercut UC may be formed under each of the plurality of second structure layers 131.

Due to the overcoat layer 120 and the first structure layer 121 formed by patterning the overcoat film 120a in this way, a side surface of the power connection line 112 and a partial area of the upper surface of the power connection line 112 defining the undercut UC may be exposed to the outside.

Moreover, a portion of the overcoat film 120a in an area between the power connection line 112 and the overcoat layer 120 may be removed such that the second insulating layer 103 may be exposed to the outside.

Moreover, a portion of the overcoat film 120a on the data line DL may be removed such that the data line DL may be exposed to the outside. A portion of the overcoat film 120a in an area between the data line DL and the power connection line 112 may be removed such that the second insulating layer 103 may be exposed to the outside.

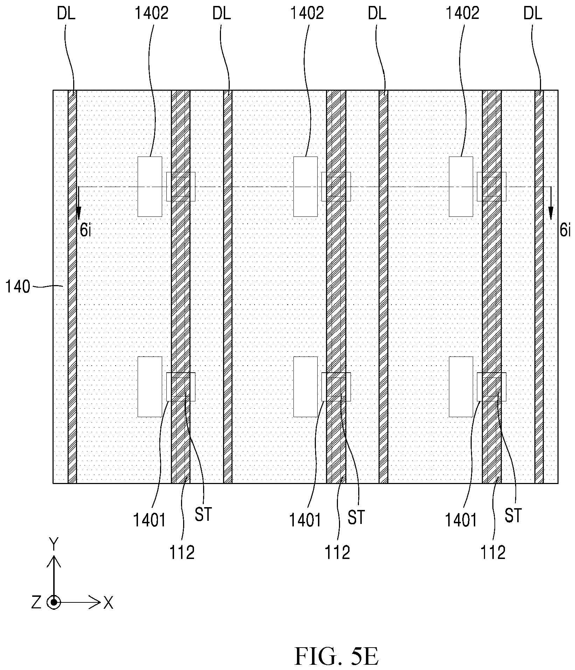

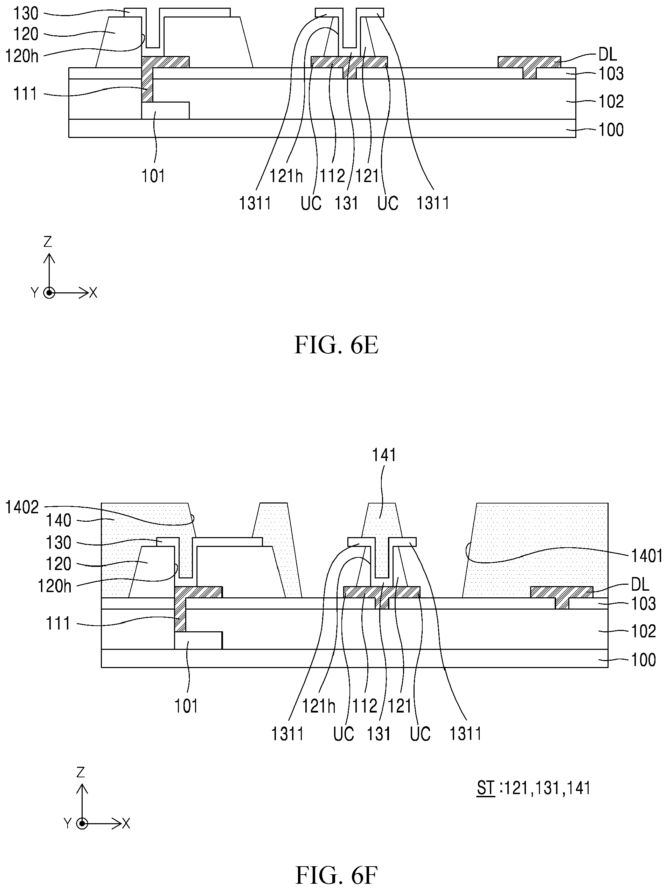

Referring to FIG. 5E and FIG. 6E, the photoresist layer 132 disposed on the anode electrode layer 130 and the second structure layer 131 may be removed.

For example, the photoresist layer 132 may be removed by peeling off the same in a stripping process.

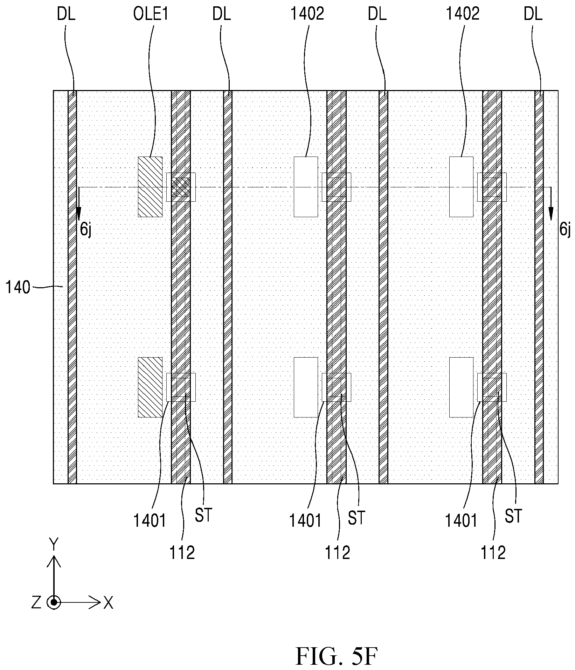

Referring to FIG. 5F and FIG. 6F, the bank layer 140 having a plurality of first openings 1401 respectively exposing the outer perimeters of the plurality of undercuts UC and a plurality of second openings 1402 respectively exposing portions of the plurality of anode electrode layers 130 defined therein may be formed.

The bank layer 140 may be formed to cover an entirety of the display area AA except for an area corresponding to each of the first opening 1401 and the second opening 1402.

The third structure layer 141 formed by patterning the bank layer 140 may be formed on the second structure layer 131.

The third structure layer 141, and the first opening 1401 and the second opening 1402 may be formed in the same patterning process.

The third structure layer 141 may be formed in a tapered shape in which the width thereof decreases as the third structure layer 141 extends upwards.

As the lower surface of the third structure layer 141 is formed to have a width smaller than that of the upper surface of the second structure layer 131, at least a partial area of the protrusion 1311 of the second structure layer 131 may not be covered with the third structure layer 141 and may be exposed to the outside.

In this way, the first structure layer 121, the second structure layer 131, and the third structure layer 141 are sequentially stacked to constitute the structure ST.

in this case, the second structure layer 131 of the structure ST may provide an overhang structure. Due to the overhang structure of the second structure layer 131, electrical connection between the cathode electrode layer and the power connection line 112 may be made at the underlying undercut UC.

As described above, both the first structure layer 121 and the third structure layer 141 of structure ST may be formed in a tapered shape.

If the third structure layer 141 has a reverse-taper shape in which a width thereof increases as the third structure layer 141 extends upwardly, the organic light-emissive layer may invade deeply into the undercut UC of the structure ST when depositing the organic light-emissive layer as described later.

Accordingly, it may be difficult for the cathode electrode layer formed in a subsequent process to contact the power connection line 112 at the undercut UC. This may disallow the stable connection between the cathode electrode layer and the power connection line.

Accordingly, if the third structure layer 141 has the reverse-taper shape, a width of the upper surface of the third structure layer 141 should be increased for stable connection between the cathode electrode layer and the power connection line. In this case, a length of the overhang structure should be increased.

However, when the length of the overhang structure increases in this way, a total area occupied by the structure ST increases, which may be disadvantageous in terms of an aperture ratio of the display device.

Therefore, in accordance with an embodiment of the present disclosure, both the first structure layer 121 and the third structure layer 141 may be formed in a tapered shape, and the second structure layer 131 as the middle structure layer may have the overhang structure, thereby providing the stable connection between the cathode electrode layer and the power connection line without increasing a size of the structure ST and thus without increasing the length of the overhang structure.

The structure ST formed in this way may be positioned in the first opening 1401 of the bank layer 140.

That is, the first opening 1401 of the bank layer 140 may be formed to surround the structure ST.

Moreover, the first opening 1401 may be opened to expose the partial area of the power connection line 112 defining the undercut UC and a partial area of the upper surface of the second insulating layer 103.

In this way, each of the plurality of structures ST and each of the plurality of first openings 1401 formed in each of the sub-pixels may be positioned on the power connection line 112 extending in one direction and may overlap the power connection line 112 in the plan view.

A pixel definition layer PDL defining each sub-pixel may be defined by the second opening 1402 of the bank layer 140.

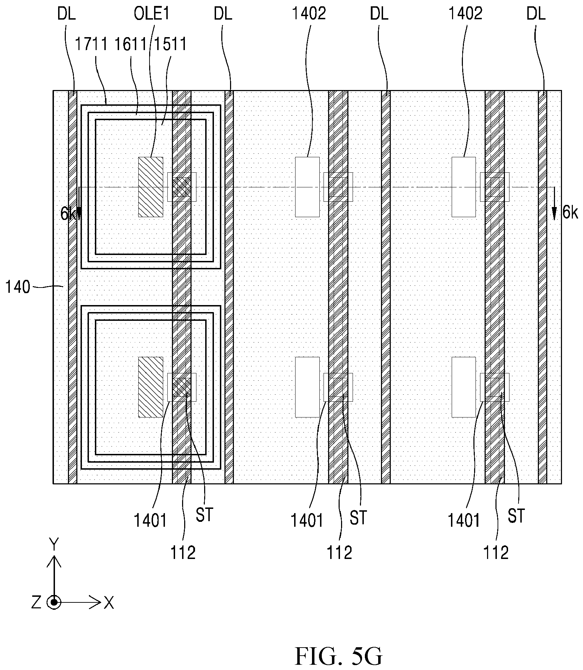

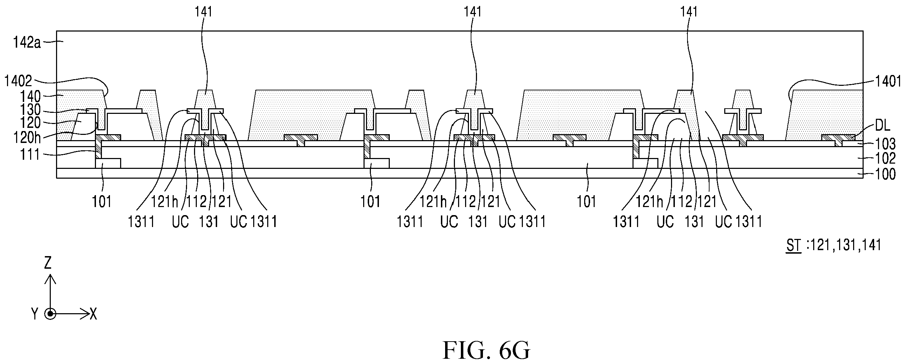

Referring to FIG. 5G and FIG. 6G, a first protective film 142a may be formed to cover an entirety of the substrate 100.

The first protective film 142a may include a fluorine-based material.

For example, the first protective film 142a may be made of a fluoropolymer material having a carbon-carbon backbone and a functional group containing a large amount of fluorine (F).

According to an example of the present disclosure, a chemical structure of the fluoropolymer material having the functional group containing a large amount of fluorine (F) has a following [Chemical Formula 1]:

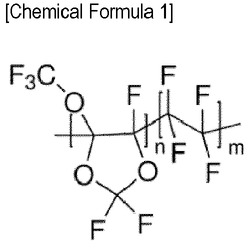

As shown in the [Chemical Formula 1], the fluoropolymer used as a material of the protective film has the functional group containing a large amount of fluorine (F).

The fluoropolymer having the functional group containing a large amount of fluorine (F) may have orthogonality.

The orthogonality may be understood as a property in which two elements are independent of each other.

Accordingly, the first protective film 142a may have both hydrophobic properties with low affinity to water and oleophobic properties with low affinity to oil.

Due to this orthogonality, the first protective film 142a may block a path through which moisture permeates due to characteristics of rejecting the moisture.

Moreover, the first protective film 142a may be less affected by a developer containing an organic solvent used in a process step. This may reduce damage to an organic material by the organic solvent.

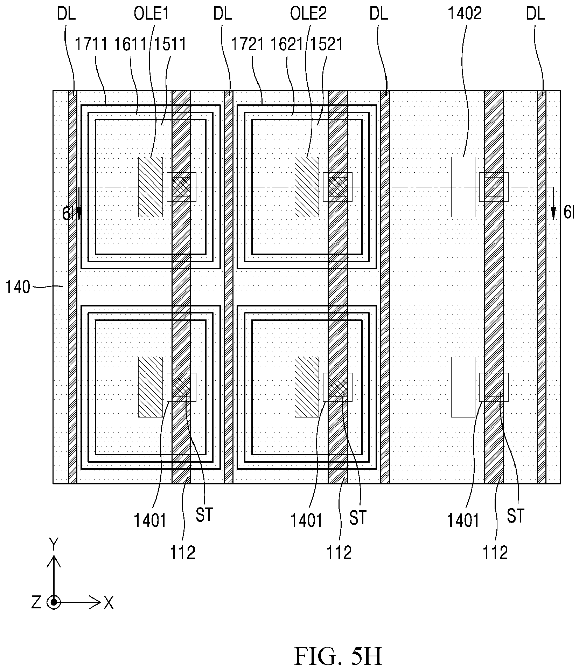

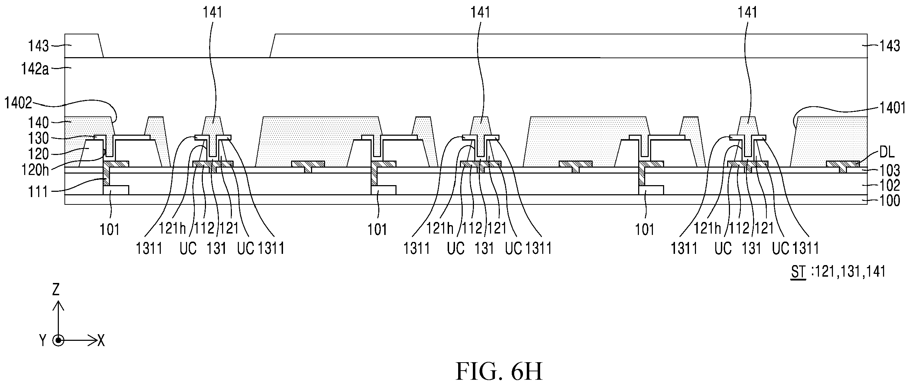

Referring to FIG. 5H and FIG. 6H, a first photoresist film 143 may be formed on the first protective film 142a.

For example, the first photoresist film 143 may be formed by depositing a photoresist material and patterning the same so as to have a predetermined pattern.

The first photoresist film 143 may have the predetermined pattern in which the first photoresist film 143 has an opening in an area corresponding to the first sub-pixel SP1, while the first photoresist film 143 does not have an opening in an area corresponding to each of the second sub-pixel SP2 and the third sub-pixel SP3 but covers the second sub-pixel SP2 and the third sub-pixel SP3.

Specifically, the first photoresist film 143 may be formed in the pattern such that a portion of an upper surface of the first protective film 142a corresponding to each of the first opening 1401 and the second opening 1402 of the first sub-pixel SP1 may be exposed.

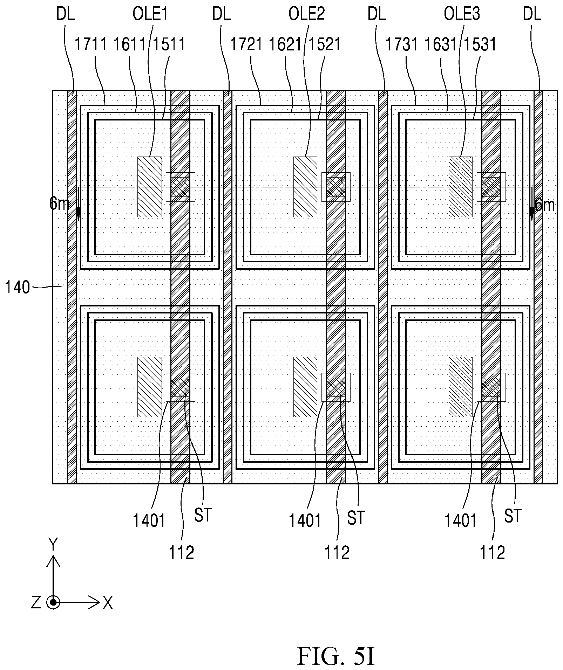

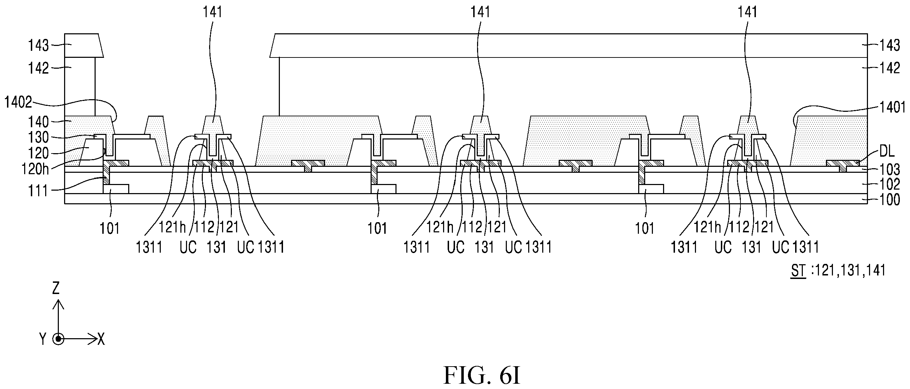

Referring to FIG. 5I and FIG. 6I, a first protective layer 142 having a predetermined pattern may be formed by patterning the underlying first protective film 142a using the first photoresist film 143 as a photo mask.

The first protective layer 142 formed in this way may not cover the first opening 1401 and the second opening 1402 of the bank layer 140 so as to be exposed to the outside.

In this case, as the first protective layer 142 is positioned inwardly of the first photoresist film 143 disposed thereon, the first photoresist film 143 may have an overhang structure on the first protective layer 142.

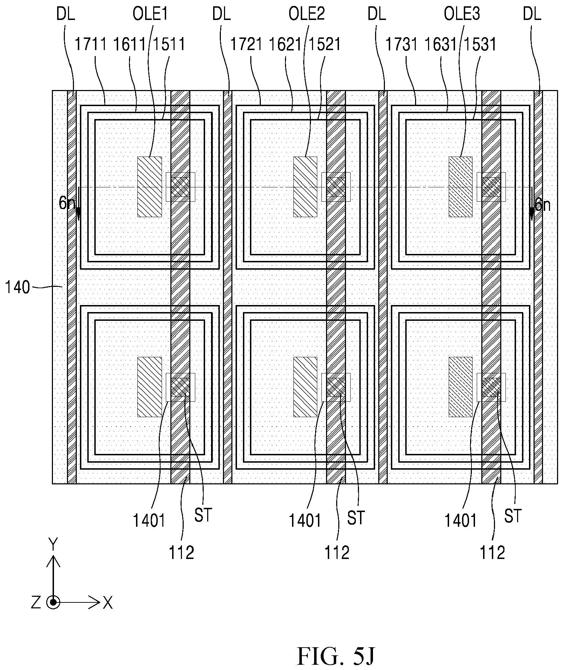

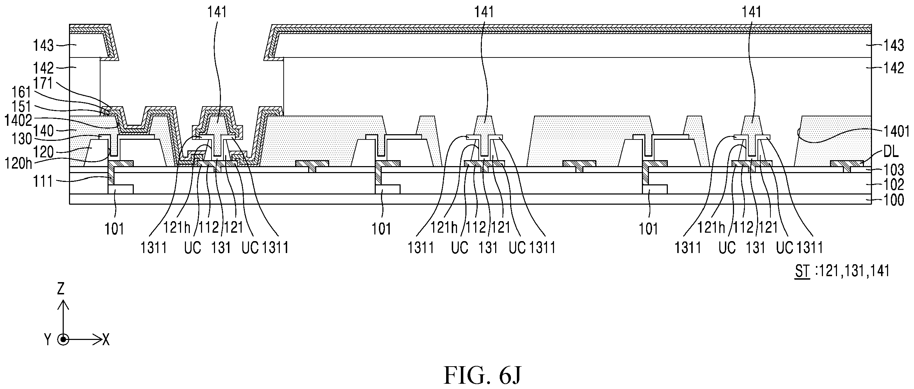

Referring to FIG. 5J and FIG. 6J, the first organic light-emissive layer 151 rendering the first color, the first cathode electrode layer 161, and the first passivation layer 171 may be sequentially stacked.

For example, the first organic light-emissive layer 151 rendering the first color, the first cathode electrode layer 161, and the first passivation layer 171 may be sequentially deposited on an entire surface of the substrate 100.

Accordingly, the first organic light-emissive layer 151, the first cathode electrode layer 161, and the first passivation layer 171 may be sequentially stacked on the first opening 1401 and the second opening 1402 of the bank layer 140. The first organic light-emissive layer 151, the first cathode electrode layer 161, and the first passivation layer 171 may be present in an isolated island manner on the structure ST having the overhang structure. That is, the first organic light-emissive layer 151, the first cathode electrode layer 161, and the first passivation layer 171 may be discontinuous.

Moreover, the first organic light-emissive layer 151, the first cathode electrode layer 161, and the first passivation layer 171 may be present in an isolated island manner on the first photoresist film 143 having another overhang structure and thus may be discontinuous, and may not be present on a side surface of the first protective layer 142.

A first spacing between the first passivation layer 171 and a center of the structure ST may be the smallest. A second spacing between the first cathode electrode layer 161 and the center of the structure ST may be larger than the first spacing. A third spacing between the first organic light-emissive layer 151 and the center of the structure ST may be larger than the second spacing.

Specifically, the first cathode electrode layer 161 may be made of a material with a relatively superior step coverage than that of a material of the first organic light-emissive layer 151. Accordingly, an end of the first cathode electrode layer 161 adjacent to the undercut UC may be positioned closer to the inner side of the undercut UC, that is, the structure ST at an end of the first organic light-emissive layer 151 adjacent to the undercut UC may be.

Therefore, the first cathode electrode layer 161 is formed to cover an entirety of the first organic light-emissive layer 151. Thus, the outermost boundary 1611 of the first cathode electrode layer 161 may be positioned outwardly of the outermost boundary 1511 of the first organic light-emissive layer 151.

The first cathode electrode layer 161 formed in this way may be in contact with the partial area of the power connection line 112 at the undercut UC, and thus may be electrically connected to the power connection line 112.

Accordingly, the first cathode electrode layers 161 disconnected from each other may be electrically connected to the power line 20 via one power connection line 112 extending across the plurality of the first sub-pixel SP1. Thus, the low-potential voltage may be applied thereto.

The first passivation layer 171 formed on the first cathode electrode layer 161 may be formed in the first opening 1401 so as to contact the partial area of the undercut UC.

However, the present disclosure is not limited thereto, and the first passivation layer 171 may additionally contact a side surface of the first structure layer 121. Alternatively, the first passivation layer 171 may contact a side surface of the first structure layer 121 of the structure ST while not directly contacting the undercut UC.

The first passivation layer 171 may be made of a material having a relatively superior step coverage to that of a material of the first cathode electrode layer 161. Thus, an end of the first passivation layer 171 adjacent to the undercut UC may be positioned closer to the inner side of the undercut UC, that is, the structure ST than an end of the first cathode electrode layer 161 adjacent to the undercut UC may be.

Therefore, the first passivation layer 171 may be formed to cover an entirety of the first cathode electrode layer 161. Thus, the outermost boundary 1711 of the first passivation layer 171 may be positioned outwardly of the outermost boundary 1611 of the first cathode electrode layer 161.

As the first organic light-emissive layer 151, the first cathode electrode layer 161, and the first passivation layer 171 are sequentially stacked in the second opening 1402, the first organic light-emissive layer 151, an area where the first cathode electrode layer 161 and the anode electrode layer 130 overlap each other may be implemented as the first light-emissive area OLE1.

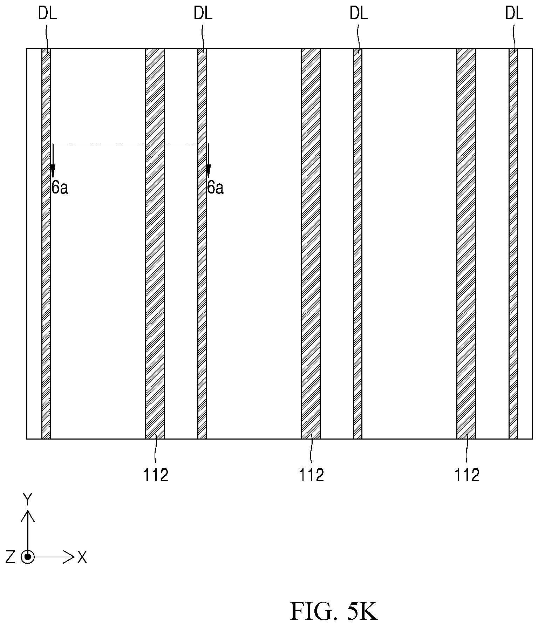

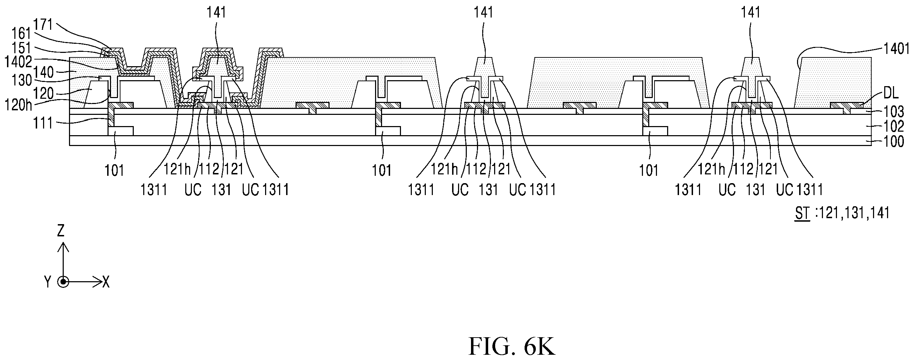

Referring to FIG. 5K and FIG. 6K, the first protective layer 142 and the first photoresist film 143 may be removed.

Specifically, the first photoresist film 143, the first organic light-emissive layer 151, the first cathode electrode layer 161, and the first passivation layer 171 stacked on the first protective layer 142 may be removed together in a process of stripping the first protective layer 142.

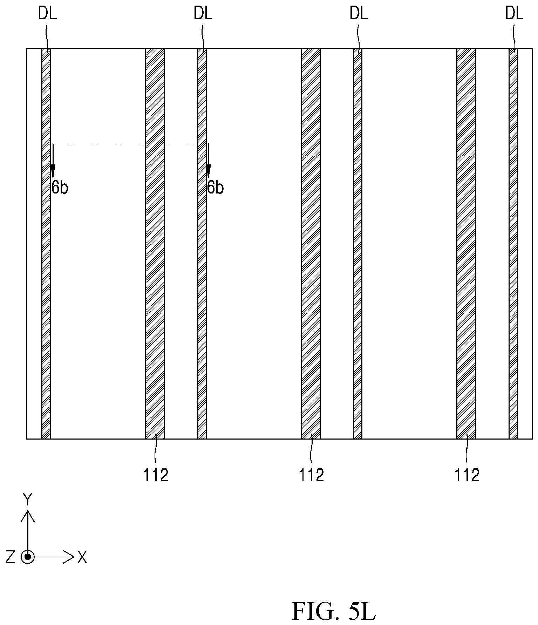

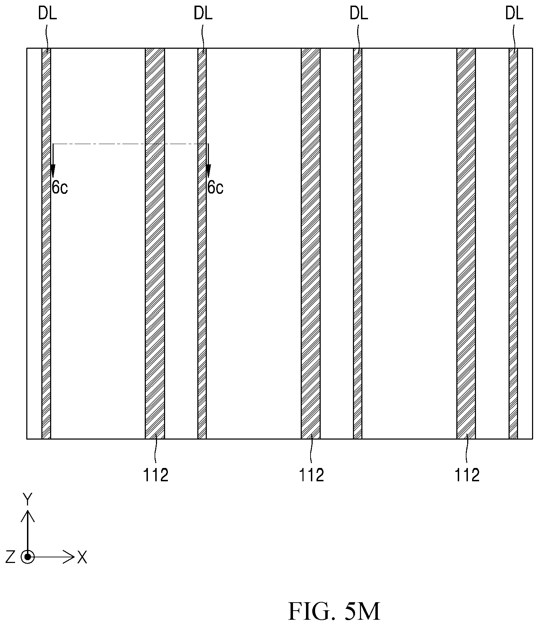

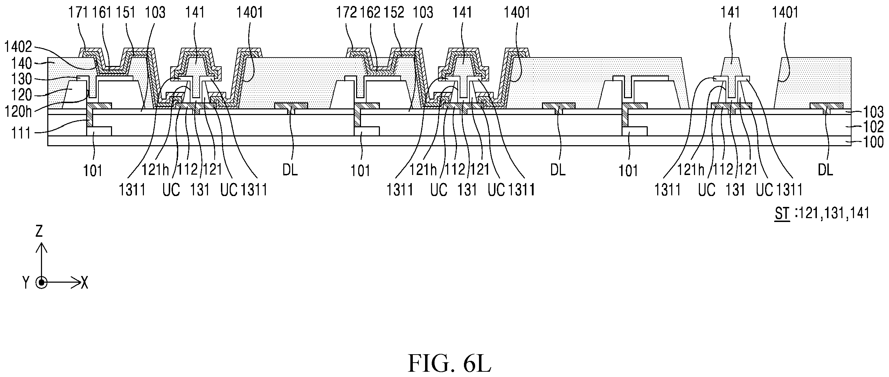

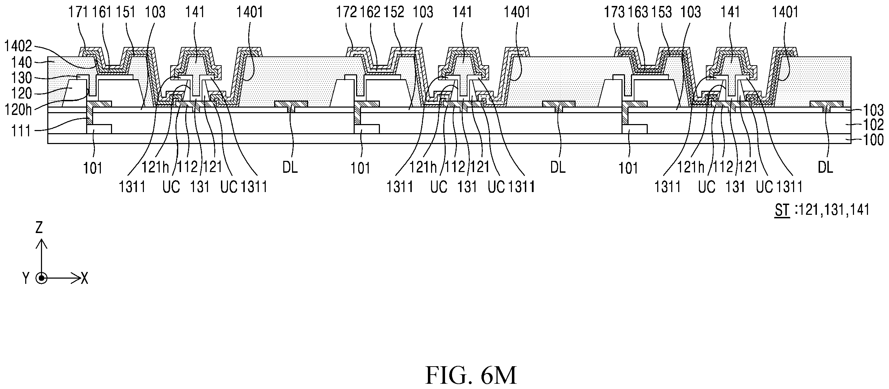

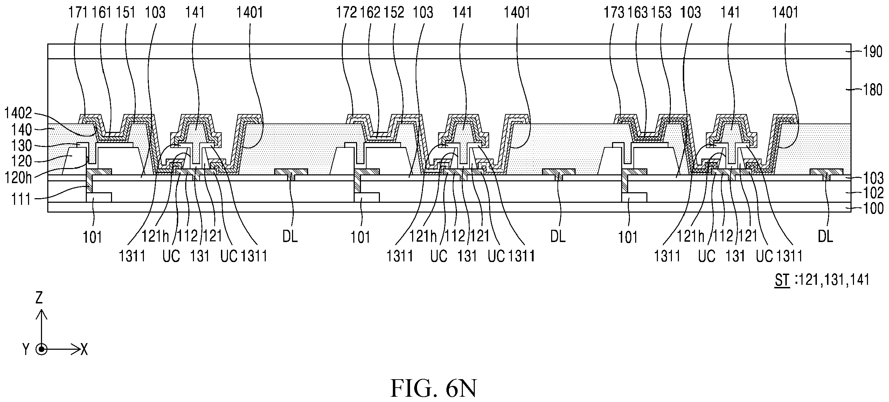

Referring to FIG. 5L, FIG. 5M, FIG. 6Land FIG. 6M, the process applied to the first sub-pixel SP1 as described in FIG. 5G to FIG. 5K and FIG. 6G to FIG. 6K may be equally performed on the second sub-pixel SP2 and the third sub-pixel SP3.

Specifically, a second protective layer and a second photoresist film may be formed to expose the first opening 1401 and the second opening 1402 corresponding to the second sub-pixel SP2. The second organic light-emissive layer 152 rendering the second color, the second cathode electrode layer 162, and the second passivation layer 172 may be sequentially stacked. Then, the second protective layer and the second photoresist film may be removed.

Accordingly, the second light-emissive area OLE2 of the second sub-pixel SP2 may be formed. The power connection line 112 extending across the second sub-pixels SP2 and the second cathode electrode layer 162 may be electrically connected to each other at the undercut UC of the structure ST of each of the second sub-pixels SP2.

After the process on the second sub-pixel SP2 has been performed in this manner, a third protective layer and a third photoresist film may be formed to expose the first opening 1401 and the second opening 1402 corresponding to the third sub-pixel SP3. The third organic light-emissive layer 153 rendering the third color, the third cathode electrode layer 163, and the third passivation layer 173 may be sequentially stacked. Then, the third protective layer and the third photoresist film may be removed.

Accordingly, the third light-emissive area OLE3 of the third sub-pixel SP3 may be formed. the power connection line 112 extending across the third sub-pixels SP3 and the third cathode electrode layer 163 may be electrically connected to each other at the undercut UC of the structure ST of each of the third sub-pixels SP3.

As such, according to an embodiment of the present disclosure, the organic light-emissive layer configured to render the first color, the cathode electrode layer, and the passivation layer may be formed, and subsequently, the organic light-emissive layer configured to render the second color may be additionally formed using the same process as that on the organic light-emissive layer configured to render the first color and subsequently, the organic light-emissive layer configured to render the third color may be additionally formed using the same process as that on the organic light-emissive layer configured to render the first color.

Therefore, the passivation layer disposed on the organic light-emissive layer may act as a protective film that reduces deterioration of the organic light-emissive layer that may occur in a continuous process for forming the organic light-emissive layers corresponding to the sub-pixels. Thus, the damage to the organic light-emissive layer may be reduced.

Moreover, according to an embodiment of the present disclosure, the contact between the cathode electrode layer and the power connection line 112 at the undercut UC of the structure ST may be made not on the bank layer 140, but in the opening where the bank layer 140 has been partially removed. Accordingly, the overall number of mask processes may be reduced.

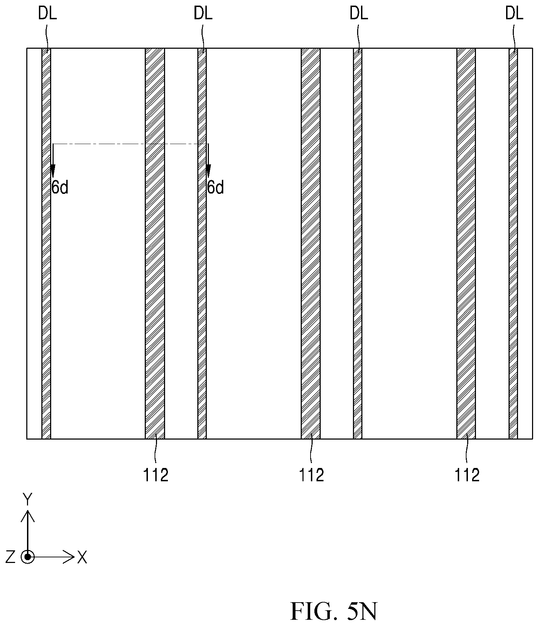

Referring to FIG. 5N and FIG. 6N, a capping layer 180 and a fourth passivation layer 190 may be additionally formed to cover the first sub-pixel SP1, the second sub-pixel SP2, and the third sub-pixel SP3.

The display device and the method for manufacturing the display device according to an embodiment of the present disclosure as described above may be described as follows.

A display device according to a first aspect of the present disclosure includes a plurality of sub-pixels; a power line for applying a voltage to the plurality of sub-pixels; and a plurality of power connection lines electrically connecting the plurality of sub-pixels to the power line.

in this case, each of the sub-pixels includes an organic light-emissive layer, a cathode electrode layer, and a passivation layer stacked sequentially, wherein the organic light-emissive layers of the sub-pixels adjacent to each other are disconnected from each other, wherein the cathode electrode layers of the sub-pixels adjacent to each other are disconnected from each other, wherein the passivation layers of the sub-pixels adjacent to each other are disconnected from each other, wherein each of the sub-pixels includes a structure providing an undercut, wherein the power connection line is disposed to overlap the structure such that the power connection line is electrically connected to the cathode electrode layer at the undercut.

In one implementation of the first aspect, the display device further comprises a plurality of data lines, each data line being disposed between the sub-pixels adjacent to each other, wherein each of the data lines is disposed so as not to overlap with the cathode electrode layer.

In one implementation of the first aspect, the plurality of data lines and the plurality of power connection lines are alternately arranged with each other and extend in a first direction, wherein the plurality of data lines and the plurality of power connection lines are arranged so as not to overlap each other.

In one implementation of the first aspect, the plurality of sub-pixels are arranged in a matrix form along a first direction and a second direction intersecting the first direction, wherein each of the power connection lines extends in the first direction so as to electrically connect the plurality of sub-pixels arranged in the first direction to the power line.

In one implementation of the first aspect, each of the sub-pixels includes an outermost boundary of the organic light-emissive layer, an outermost boundary of the cathode electrode layer, and an outermost boundary of the passivation layer, wherein the outermost boundary of the organic light-emissive layer is positioned inwardly of the outermost boundary of the passivation layer, wherein the outermost boundary of the cathode electrode layer is disposed between the outermost boundary of the organic light-emissive layer and the outermost boundary of the passivation layer.

In one implementation of the first aspect, the structure included in each of the sub-pixels is positioned inwardly of the outermost boundary of the organic light-emissive layer, the outermost boundary of the cathode electrode layer, and the outermost boundary of the passivation layer.

In one implementation of the first aspect, the power line is a low-potential voltage (VSS) line, wherein a low-potential voltage is applied to the cathode electrode layer included in each of the sub-pixels via the power connection line.

Moreover, a display device according to a second aspect of the present disclosure includes a substrate having a plurality of sub-pixel areas defined thereon; a plurality of power connection lines disposed on the substrate; a plurality of structures, wherein each structure is included in each sub-pixel and is disposed on the power connection line, and provides an undercut exposing a portion of the power connection line; a bank layer disposed on the power connection line and including a first opening defined therein to expose the undercut; and an organic light-emissive layer, a cathode electrode layer, and a passivation layer sequentially stacked so as to cover the bank layer and the structure.

In this case, the power connection line is electrically connected to the cathode electrode layer at the undercut, wherein the organic light-emissive layers of the sub-pixels adjacent to each other are disconnected from each other, wherein the cathode electrode layers of the sub-pixels adjacent to each other are disconnected from each other, wherein the passivation layers of the sub-pixels adjacent to each other are disconnected from each other.

In one implementation of the second aspect, the display device further comprises: a plurality of thin-film transistors disposed on the substrate, wherein each of the plurality of thin-film transistors is included in each of the sub-pixels, and includes source and drain electrodes; and a plurality of data lines disposed on the substrate, wherein the power connection lines, the source and drain electrodes, and the data lines are disposed in the same layer, and are made of the same material.

In one implementation of the second aspect, a bank layer is disposed on the data line so as to overlap the data line, wherein the data line is disposed so as not to overlap with the cathode electrode layer.

In one implementation of the second aspect, the display device further comprises: an overcoat layer disposed on the source and drain electrodes; and an anode electrode layer disposed between the overcoat layer and the bank layer so as to be electrically connected to the source and drain electrodes, wherein the structure includes a first structure layer, a second structure layer, and a third structure layer stacked sequentially, wherein the first structure layer and the overcoat layer are disposed in the same layer and are made of the same material, wherein the second structure layer and the anode electrode layer are disposed in the same layer and are made of the same material, wherein the third structure layer and the bank layer are disposed in the same layer, and are made of the same material.

In one implementation of the second aspect, each of the first structure layer and the third structure layer has a taper shape.

In one implementation of the second aspect, the second structure layer is electrically connected to the power connection line via a contact-hole formed in the first structure layer.

In one implementation of the second aspect, the second structure layer includes a protrusion protruding outwardly beyond each of the first structure layer and the third structure layer.

In one implementation of the second aspect, the cathode electrode layer disposed on the structure is electrically connected to the protrusion.

In one implementation of the second aspect, the display device further comprises a power line as a low-potential voltage (VSS) line, wherein a low-potential voltage is applied to the cathode electrode layer included in each of the sub-pixels via the power connection line electrically connected to the power line.

Further, a method for manufacturing a display device according to a third aspect of the present disclosure includes forming a plurality of source and drain electrodes, a plurality of power connection lines, and a plurality of data lines on a substrate, and forming an overcoat layer thereon; forming a plurality of anode electrode layers and a plurality of second structure layers on the overcoat layer, wherein the plurality of anode electrode layers are electrically connected to the plurality of source and drain electrodes, respectively, wherein the plurality of second structure layers are electrically connected to the plurality of power connection lines, respectively; patterning the overcoat layer to form a plurality of first structure layers respectively under the plurality of the second structure layers, wherein each of the plurality of first structure layers provides an undercut; forming a bank layer having a plurality of first openings and a plurality of second openings defined therein, wherein each of the plurality of first openings exposes an outer periphery of each of the plurality of undercuts, wherein each of the plurality of second openings exposes a portion of each of the plurality of anode electrode layers; forming a first protective layer and a first photoresist film so as to expose the first opening and the second opening corresponding to a first sub-pixel, sequentially forming a first organic light-emissive layer rendering a first color, a first cathode electrode layer, and a first passivation layer, and then removing the first protective layer and the first photoresist film; forming a second protective layer and a second photoresist film so as to expose the first opening and the second opening corresponding to a second sub-pixel, sequentially forming a second organic light-emissive layer rendering a second color, a second cathode electrode layer, and a second passivation layer, and then removing the second protective layer and the second photoresist film after; and forming a third protective layer and a third photoresist film so as to expose the first opening and the second opening corresponding to a third sub-pixel, sequentially forming a third organic light-emissive layer rendering the third color, a third cathode electrode layer, and a third passivation layer, and then removing the third protective layer and the third photoresist film.

In one implementation of the third aspect, forming the bank layer includes forming a third structure layer on the second structure layer, wherein the third structure layer and the first opening and the second opening are formed in the same patterning process.

In one implementation of the third aspect, the first organic light-emissive layer, the second organic light-emissive layer, and the third organic light-emissive layer are formed so as to be disconnected from each other, wherein the first cathode electrode layer, the second cathode electrode layer, and the third cathode electrode layer are formed so as to be disconnected from each other, wherein the first passivation layer, the second passivation layer, and the third passivation layer are formed so as to be disconnected from each other.

Further, a method for manufacturing a display device according to a third aspect of the present disclosure includes forming a plurality of source and drain electrodes, a plurality of power connection lines, and a plurality of data lines on a substrate, and forming an overcoat layer thereon; forming a plurality of anode electrode layers and a plurality of second structure layers on the overcoat layer, wherein the plurality of anode electrode layers are electrically connected to the plurality of source and drain electrodes, respectively, wherein the plurality of second structure layers are electrically connected to the plurality of power connection lines, respectively; patterning the overcoat layer to form a plurality of first structure layers respectively under the plurality of the second structure layers, wherein each of the plurality of first structure layers provides an undercut; forming a bank layer having a plurality of first openings and a plurality of second openings defined therein, wherein each of the plurality of first openings exposes an outer periphery of each of the plurality of undercuts, wherein each of the plurality of second openings exposes a portion of each of the plurality of anode electrode layers; forming a first protective layer and a first photoresist film so as to cover the substrate, and patterning the first protective layer and the first photoresist film so as to expose the first opening and the second opening corresponding to a first sub-pixel, sequentially forming a first organic light-emissive layer configured to render a first color, a first cathode electrode layer, and a first passivation layer, and then removing the first protective layer and the first photoresist film; forming a second protective layer and a second photoresist film so as to cover the substrate, and patterning the second protective layer and the second photoresist film so as to expose the first opening and the second opening corresponding to a second sub-pixel, sequentially forming a second organic light-emissive layer configured to render a second color, a second cathode electrode layer, and a second passivation layer, and then removing the second protective layer and the second photoresist film; and forming a third protective layer and a third photoresist film so as to cover the substrate, and patterning the third protective layer and the third photoresist film so as to expose the first opening and the second opening corresponding to a third sub-pixel, sequentially forming a third organic light-emissive layer configured to render the third color, a third cathode electrode layer, and a third passivation layer, and then removing the third protective layer and the third photoresist film.

In one implementation of the third aspect, forming the bank layer includes forming a third structure layer on the second structure layer, wherein the third structure layer and the first opening and the second opening are formed in the same patterning process.

In one implementation of the third aspect, the first organic light-emissive layer, the second organic light-emissive layer, and the third organic light-emissive layer are formed so as to be disconnected from each other, wherein the first cathode electrode layer, the second cathode electrode layer, and the third cathode electrode layer are formed so as to be disconnected from each other, wherein the first passivation layer, the second passivation layer, and the third passivation layer are formed so as to be disconnected from each other.

Although the embodiments of the present disclosure have been described in more detail with reference to the accompanying drawings, the present disclosure is not necessarily limited to these embodiments, and may be modified in a various manner within the scope of the present disclosure. Accordingly, the embodiments as disclosed in the present disclosure are intended to describe rather than limit the technical idea of the present disclosure, and the scope of the technical idea of the present disclosure is not limited by these embodiments. Therefore, it should be understood that the embodiments described above are not restrictive but illustrative in all respects.
The following numbered clauses are also disclosed herein:
1. A method for manufacturing a display device, the method comprising:
   forming a plurality of source and drain electrodes, a plurality of power connection lines, and a plurality of data lines on a substrate, and forming an overcoat layer thereon;
   forming a plurality of anode electrode layers and a plurality of second structure layers on the overcoat layer, wherein the plurality of anode electrode layers are electrically connected to the plurality of source and drain electrodes, respectively, wherein the plurality of second structure layers are electrically connected to the plurality of power connection lines, respectively;
   patterning the overcoat layer to form a plurality of first structure layers respectively under the plurality of the second structure layers, wherein each of the plurality of first structure layers provides an undercut;
   forming a bank layer having a plurality of first openings and a plurality of second openings defined therein, wherein each of the plurality of first openings exposes an outer periphery of each of the plurality of undercuts, wherein each of the plurality of second openings exposes a portion of each of the plurality of anode electrode layers;
   forming a first protective layer and a first photoresist film so as to cover the substrate, and patterning the first protective layer and the first photoresist film so as to expose the first opening and the second opening corresponding to a first sub-pixel, sequentially forming a first organic light-emissive layer configured to render a first color, a first cathode electrode layer, and a first passivation layer, and then removing the first protective layer and the first photoresist film;
   forming a second protective layer and a second photoresist film so as to cover the substrate, and patterning the second protective layer and the second photoresist film so as to expose the first opening and the second opening corresponding to a second sub-pixel, sequentially forming a second organic light-emissive layer configured to render a second color, a second cathode electrode layer, and a second passivation layer, and then removing the second protective layer and the second photoresist film; and
   forming a third protective layer and a third photoresist film so as to cover the substrate, and patterning the third protective layer and the third photoresist film so as to expose the first opening and the second opening corresponding to a third sub-pixel, sequentially forming a third organic light-emissive layer configured to render the third color, a third cathode electrode layer, and a third passivation layer, and then removing the third protective layer and the third photoresist film.
2. The method of clause 1, wherein forming the bank layer includes forming a third structure layer on the second structure layer,
   wherein the third structure layer and the first opening and the second opening are formed in the same patterning process.
3. The method of clause 1 or 2, wherein the first organic light-emissive layer, the second organic light-emissive layer, and the third organic light-emissive layer are formed so as to be disconnected from each other,
   wherein the first cathode electrode layer, the second cathode electrode layer, and the third cathode electrode layer are formed so as to be disconnected from each other,
   wherein the first passivation layer, the second passivation layer, and the third passivation layer are formed so as to be disconnected from each other.

## Claims

1. A display device (1) comprising:
a plurality of sub-pixels (SP1, SP2, SP3);
a power line (20) for applying a voltage to the plurality of sub-pixels; and
a plurality of power connection lines (112) electrically connecting the plurality of sub-pixels to the power line,
wherein each of the plurality of sub-pixels includes an organic light-emissive layer (151, 152, 153), a cathode electrode layer (161, 162, 163) on the organic light-emissive layer, and a passivation layer (171, 172, 173) on the cathode electrode layer,
wherein organic light-emissive layers of sub-pixels from the plurality of sub-pixels that are adjacent to each other are disconnected from each other,
wherein cathode electrode layers of the sub-pixels adjacent to each other are disconnected from each other,
wherein passivation layers of the sub-pixels adjacent to each other are disconnected from each other,
wherein each of the sub-pixels includes a structure (ST) including an undercut (UC),
wherein each of the plurality of power connection lines overlaps the structure such that the power connection line is electrically connected to a cathode electrode layer from the cathode electrode layers at the undercut.

2. The display device of claim 1, wherein the display device further comprises a plurality of data lines (DL), each of the plurality of data lines between the sub-pixels (SP1, SP2, SP3) adjacent to each other,
wherein each of the plurality of data lines is non-overlapping with the cathode electrode layer (161, 162, 163).

3. The display device of claim 2, wherein the plurality of data lines (DL) and the plurality of power connection lines (112) are alternately arranged with each other and extend in a first direction,
wherein the plurality of data lines and the plurality of power connection lines are arranged so as to be non-overlapping each other.

4. The display device of any preceding claim, wherein the plurality of sub-pixels (SP1, SP2, SP3) are arranged in a matrix form along a first direction and a second direction intersecting the first direction,
wherein each of the plurality of power connection lines (112) extends in the first direction so as to electrically connect the plurality of sub-pixels arranged in the first direction to the power line (20).

5. The display device of any preceding claim, wherein each of the plurality of sub-pixels (SP1, SP2, SP3) includes an outermost boundary (1511, 1521, 1531) of the organic light-emissive layer (151, 152, 153), an outermost boundary (1611, 1621, 1631) of the cathode electrode layer (161, 162, 163), and an outermost boundary (1711, 1721, 1731) of the passivation layer (171, 172, 173),
wherein the outermost boundary of the organic light-emissive layer is positioned inwardly of the outermost boundary of the passivation layer,
wherein the outermost boundary of the cathode electrode layer is disposed between the outermost boundary of the organic light-emissive layer and the outermost boundary of the passivation layer.

6. The display device of claim 5, wherein the structure (ST) included in each of the plurality of sub-pixels (SP1, SP2, SP3) is positioned inwardly of the outermost boundary (1511, 1521, 1531) of the organic light-emissive layer (151, 152, 153), the outermost boundary (1611, 1621, 1631) of the cathode electrode layer (161, 162, 163), and the outermost boundary (1711, 1721, 1731) of the passivation layer (171, 172, 173).

7. The display device of any preceding claim, wherein the power line (20) is a low-potential voltage, VSS line,
and a low-potential voltage can be applied to the cathode electrode layer (161, 162, 163) included in each of the plurality of sub-pixels (SP1, SP2, SP3) via the power connection line (112).

8. The display device of claim 1 comprising:
a substrate (100) having the plurality of sub-pixel areas;
the plurality of power connection lines (112) on the substrate;
a bank layer (140) on each power connection line (112) and including a first opening (1401) that exposes the undercut (UC); and
wherein each organic light-emissive layer (151, 152, 153), cathode electrode layer (161, 162, 163), and passivation layer (171, 172, 173) are sequentially stacked so as to cover the respective bank layer and the respective structure (ST).

9. The display device of claim 8, wherein the display device further comprises:
a plurality of thin-film transistors on the substrate (100), wherein each of the plurality of thin-film transistors is included in each of the plurality of sub-pixel (SP1, SP2, SP3) areas, and includes source and drain electrodes (111); and
a plurality of data lines on the substrate,
wherein the plurality of power connection lines (112), the source and drain electrodes, and the plurality of data lines are in a same layer, and are made of a same material.

10. The display device of claim 9, wherein a bank layer (140) is on a data line from the plurality of data lines and overlaps the data line,
wherein the data line is non-overlapping with the cathode electrode layer (161, 162, 163).

11. The display device of claim 9 or 10, wherein the display device further comprises:
an overcoat layer (120) on the source and drain electrodes (111); and
an anode electrode layer (130) between the overcoat layer and the bank layer (140), the anode electrode layer electrically connected to the source and drain electrodes,
wherein at least one of the plurality of structures (ST) includes a first structure layer (121), a second structure layer (131), and a third structure layer (141) stacked sequentially,
wherein the first structure layer and the overcoat layer are in a same layer and are made of a same material,
wherein the second structure layer and the anode electrode layer in a same layer and are made of a same material,
wherein the third structure layer and the bank layer are in a same layer, and are made of a same material.

12. The display device of claim 11, wherein each of the first structure layer (121) and the third structure layer (141) has a taper shape.

13. The display device of claim 11 or 12, wherein the second structure layer (131) is electrically connected to the power connection line (112) via a contact-hole (121h) in the first structure layer (121).

14. The display device of any of claims 11 to 13, wherein the second structure layer (131) includes a protrusion (1311) protruding outwardly beyond each of the first structure layer (121) and the third structure layer (141); and optionally wherein the cathode electrode layer (161, 162, 163) on the structure is electrically connected to the protrusion.

15. The display device of any of claims 8 to 14, wherein the display device further comprises a power line (20) as a low-potential voltage, VSS line,
and a low-potential voltage is applied to the cathode electrode layer (161, 162, 163) included in each of the plurality of sub-pixel (SP1, SP2, SP3) areas via the power connection line (112) electrically connected to the power line.
